# EUROPÄISCHE PATENTSCHRIFT

(11) **EP 2 529 484 B1**
(45) Veröffentlichungstag und Bekanntmachung des Hinweises auf die Patenterteilung: **25.12.2013**
(21) Anmeldenummer: 11703823.2
(22) Anmeldetag: 31.01.2011
(51) Int. Cl.: H03K 17/97, H03K 17/96

(54) **ANORDNUNG UND SYSTEM FÜR EINEN INDUKTIVEN SENSORTASTSCHALTER**
ARRANGEMENT AND SYSTEM FOR AN INDUCTIVE SENSOR PUSH-BUTTON
AGENCEMENT ET SYSTÈME POUR BOUTON-POUSSOIR DE DÉTECTION INDUCTIF

(30) Priorität: 29.01.2010 US 696458
(43) Veröffentlichungstag der Anmeldung: 05.12.2012
(60) Teilanmeldung: 13003703.9
(73) Patentinhaber: Diehl AKO Stiftung & Co. KG, 88239 Wangen (DE)
(72) Erfinder: LACEY, Kevin, Oak Park, IL 60302 (US); JOHANSEN, Scott, Aurora, IL 60506 (US); KOPEC, Jim, St. Charles, IL 60175 (US); ALVORD, Robert, Elmwood Park, IL 60607 (US); KAPS, Werner, 88171 Weiler-Simmerberg (DE)
(74) Vertreter: Diehl Patentabteilung
(86) Internationale Anmeldenummer: PCT/EP2011/000426
(87) Internationale Veröffentlichungsnummer: WO 2011/092033

(56) Entgegenhaltungen:
- DE-U1-202008 001 970
- US-A1- 2009 160 789
- US-A1- 2011 050 626
- MICROCHIP: "mTouch Inductive Touch User s Guide", 20090101, Nr. DS41407A, 1. Januar 2009 (2009-01-01), Seiten 1-34, XP007918938,
- MCCOMB M: "Inductive mTouch Sensing Solution from Microchip", MICROCHIP WEBSEMINARS,, 1. Januar 2006 (2006-01-01), Seiten 1-29, XP007918969,

## Beschreibung

Die Erfindung betrifft eine Anordnung für einen induktiven Tastschalter sowie ein System hiermit gemäß den Ansprüchen 1 und 12.

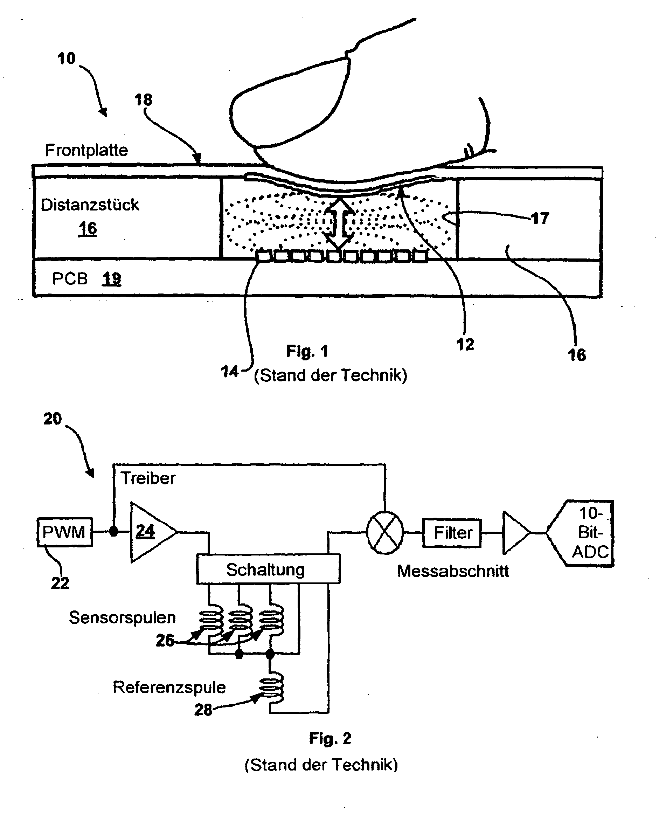

Im Grunde sind induktive Sensortastschalter und deren Schaltungen bekannt. Um auf Fig. 1 Bezug zu nehmen, hat beispielsweise MICROCHIP TECHNOLOGY INC. ("MICROCHIP"), Chandler, Arizona einen Anordnungsentwurf 10 für induktiven Sensortastschalter (den "MICROCHIP-Entwurf") veröffentlicht, der eine magnetische Kopplung zwischen einem massiven Metalltarget 12 und einer induktiven Mess- oder Sensorspule 14, die durch eine Distanzschicht 16 voneinander getrennt sind, verwendet. Die Distanzschicht 16 definiert einen Hohlraum oder eine Tasche, in die sich das massive Metalltarget 12, wenn es gedrückt wird, durchbiegen kann, womit sich seine Nähe zu der Sensorspule 14, die an einer Leiterplatte PCB 19 angebracht, auf eine solche gedruckt und/oder in eine solche geätzt ist, und das umgebende Feld verändern. Genauer bewirkt das Drücken des an einer Frontplatte 18 definierten induktiven Tastschalters, dass sich die Kopplung zwischen dem Target 12 und der Sensorspule 14 verändert, womit ein Tastendrücken angezeigt wird. Die Frontplatte 18, die auch oberste Tastschalterschicht oder Abdeckung genannt wird, kann die äußerste Haut des Produkts oder Haushaltsgeräts, wovon die Tastatur ein Teil ist, sein. Der MICROCHIP-Entwurf geht davon aus, dass Kupfer, Aluminium, Messung, Edelstahl und weicher unlegierter Stahl Materialien der Wahl für eine Abdeckungsschicht/Target-Kombination sind, jedoch könnte ein Target in Übereinstimmung mit dem Entwurf auch aus Gold und/oder Silber gefertigt sein, solange das Material eine physische Verformung des Targets über der Sensorspule zulässt. In dem MICROCHIP-Entwurf offenbarte spezifische Targetausführungsformen umfassen eine Kupferkaschierung und ein auf die Unterseite der Abdeckung gesetztes selbstklebendes bzw. -haftendes Kupferetikett. Der MICROCHIP-Entwurf führt an, dass im Allgemeinen das Target 12 die Größe und die Form der Sensorspule 14 besitzen sollte.

Es besteht ein Bedarf an einem verbesserten Targetentwurf zur Verwendung mit einem System für induktiven Sensortastschalter.

Außerdem ist in Übereinstimmung mit dem MICROCHIP-Entwurf ein Mikrocontroller vorgesehen, um verschiedene Sensoren periodisch abzufragen, indem die Impedanz einer Messspule gemessen wird. Wenn sich die Impedanz der Messspule verändert hat, ermittelt der Mikrocontroller, ob die Veränderung der Impedanz hinreichend ist, um dies als Drücken durch einen Benutzer einzustufen. Beim MICROCHIP-Entwurf sind die einzelnen Messspulen (d. h. eine für jeden Schalter) durch eine einzige gemeinsame Verbindung mit einer "Referenzspule", die als Referenzdrosselspule dient, verbunden, was eine verhältnismetrische Messung ermöglicht, die mehrere Driftquellen beseitigt. Wie in Fig. 2 gezeigt ist, verwendet die induktive Tastschaltung des MICROCHIP-Entwurfs eine einzige Treiberschaltung, um jede der Messspulen, wovon jede durch eine gemeinsame Verbindung mit der Referenzspule verbunden ist, zu treiben.

Jedoch ist bei vielen Anwendungen das äußere Material eines Tastschalters (der Abdeckung) aus einem relativ dicken, beispielsweise 0,032 bis 0,036 Zoll dicken, Stück Edelstahl gefertigt. Jedoch würde das Verwenden der beim MICROCHIP-Entwurf gelehrten Berechnungen zum Erzeugen einer 0,010 mm-Bewegung eines induktiven Tastschalters mit einer Targetabdeckungs-/Targetdicke von 0,036 Zoll bei einem Tastendrücken mit einer Kraft von 1,1 Pfund eine Messspule mit einem Durchmesser von 2,15 Zoll erfordern. Ein solcher Messspulendurchmesser wäre für das Querformat der Vorrichtungstastatur unpraktisch, d. h. würde einen Tastenabstand von mehr als 2 Zoll erfordern. Auch wurde festgestellt, dass bei solchen Materialien ein Treiberstrom so hoch sein musste, dass Wirbelströme im Metall erzeugt werden. Jedoch können höhere Treiberströme in den großen Treiberschleifen auf der PCB ein Nebensprechen und einen Verlust an Signalstärke verursachen. Außerdem können die Schaltungsschleifen Signale von externen Feldern aufnehmen (d. h., dass große Schleifen auf der PCB-Auslegung Rauschsignale aufnehmen können). Jedoch erzwingt die Verwendung von "Referenzspulen" im MICROCHIP-Entwurf die Einbeziehung großer Stromschleifen in der PCB-Auslegung, da jede Messspule in der Tastatur ihren Strom zur Referenzspule leiten muss. Diese Probleme eines stärkeren Rauschens und einer geringeren Signalstärke verschlimmern sich noch, wenn eine Tastatur eher lang als von kleiner, quadratischer Form ist.

Der MICROCHIP-Entwurf geht davon aus, dass als eine alternative Lösung die Referenzspule entfallen kann und zur Kompensation der Drift Software bereitgestellt sein kann. Jedoch offenbart der MICROCHIP-Entwurf speziell, dass eine solche Software umfangreich werden kann und die Bürde für den Mikrocontroller wesentlich zunehmen kann, wohingegen die Einbeziehung der Referenzdrosselspule auf der Karte minimal ist, weshalb der MICROCHIP-Entwurf speziell anführt, dass das Weglassen der Referenzspule nicht empfohlen wird, sobald die Zunahme des Softwareumfangs in Betracht gezogen wird.

Andere Beispiele für druckempfindliche induktive Schalter sind aus der US 2009/0160789 A1 und der DE 20 2008 001 970 U1 bekannt.

Benötigt wird ein induktiver Sensortastschalter mit Schaltung, der die Rauschunempfindlichkeit und die Signalstärke verbessert, ohne die in Verbindung mit dem MICROCHIP-Entwurf beschriebenen Hinzufügung der umfangreichen Software zu erfordern.

In Erkenntnis dieser Gegebenheiten liegt vorliegender Erfindung deshalb die Problemstellung zugrunde, eine Anordnung und ein System für einen induktiven Sensortastschalter zu schaffen, die bzw. das die Nachteile des Standes der Technik beseitigt.

Die erstgenannte Aufgabe hinsichtlich einer Anordnung wird erfindungsgemäß gelöst durch eine Anordnung für einen induktiven Sensortastschalter, die umfasst: einen Benutzerschnittstelle-Frontplattenabschnitt; eine Sensorspule, die auf einer Leiterplatte angeordnet ist; ein leitendes Target, das zwischen dem Benutzerschnittstelte-Frontplattenabschnitt und der Sensorspule angeordnet ist; einen Rahmen, der zwischen der Leiterplatte und dem Benutzerschnittstelle-Frontplattenabschnitt angeordnet ist, wobei der Rahmen einen Überbrückungsabschnitt umfasst, das bzw. der eine oberste Oberfläche, die zur unteren Oberfläche des Benutzerschnittstelle-Frontplattenabschnitts benachbart ist, und eine unterste Oberfläche, die der Sensorspule zugewandt ist, besitzt, und wobei das leitende Target nächstgelegen zur untersten Oberfläche des Überbrückungsabschnitts angeordnet ist, wodurch eine Durchbiegung des Frontplattenabschnitts über dem Rahmen zu einer Durchbiegung des Überbrückungsabschnitts und einer Bewegung wenigstens eines Abschnitts des leitenden Targets zur Sensorspule hin führt.

Die zweitgenannte Aufgabe hinsichtlich eines Systems wird erfindungsgemäß gelöst durch ein System für einen induktiven Sensortastschalter, das umfasst: mehrere Anordnungen für einen induktiven Sensortastschalter wobei jede der Anordnungen für den induktiven Sensortastschalter ein leitendes Target umfasst, das mit einer Sensorspule gekoppelt ist; mehrere Treiberschaltungen, die einen Treiberstrom erzeugen, wobei jede der mehreren Treiberschaltungen ihren eigenen Treibertransistor umfasst und wobei jede der mehreren Treiberschaltungen nur an eine der mehreren Anordnungen für induktiven Sensortastschalter einen Treiberstrom liefert.

In einer vorteilhaften Weiterbildung weist ein System mehrere Anordnungen für einen induktiven Sensortastschalter auf, wobei jede Sensorspule über eine gemeinsame Zuleitungsverbindung direkt mit Erde verbunden ist.

In einer bevorzugten Alternative umfasst die Anordnung ferner wenigstens einen Lichtemitter, der auf der Leiterplatte angeordnet ist, und wobei wenigstens ein Abschnitt des Rahmens aus einem lichtdurchlässigen Material gefertigt ist, wobei der lichtdurchlässige Abschnitt des Rahmens in optischer Verbindung mit einem emittierenden Abschnitt des wenigstens einen Lichtemitters angeordnet ist.

In einer weiteren Ausführungsform ist das Target direkt an der untersten Oberfläche eines Überbrückungsabschnitts befestigt.

Vorteilhafter Weise ist das leitende Target durch Heißprägen und/oder Drucken an der untersten Oberfläche des Überbrückungsabschnitts befestigt.

Zweckmäßiger Weise umfasst der Rahmen ferner einen Wulstabschnitt, der vom Überbrückungsabschnitt herab steht, wobei das leitende Target fern vom Überbrückungsabschnitt mit dem Wulstabschnitt in Verbindung stehend angeordnet ist.

In einer weiteren Ausgestaltung ist das leitende Target am fernen Wulstabschnitt befestigt und schwebt über der Sensorspule.

In einer besonders vorteilhaften Weiterbildung ist das leitende Target eine Metallscheibe. In einer weiteren Ausgestaltung ist das leitende Target ein Blatt eines mehrblättrigen Targets.

Vorteilhafter Weise ist das leitende Target eine leitende Kappe, die zwischen der Leiterplatte und dem Wulstabschnitt und über der Sensorspule an der Leiterplatte angebracht ist.

Zweckmäßiger Weise ist die leitende Kappe entweder eine haubenförmige oder eine kastenförmige oder eine mit Füßen versehene Scheibe.

In einer vorteilhaften Weiterbildung umfasst die Sensorspule einen ersten Satz von Windungen, die in einer ersten Richtung drehen, und einen zweiten Satz von Windungen, die in einer zweiten Richtung drehen, wobei die zweite Richtung zur ersten Richtung entgegengesetzt ist, wobei der zweite Satz von Windungen den ersten Satz von Windungen umgibt.

In einer bevorzugten Alternative umfasst die Sensorspule einen ersten Satz von Windungen, wobei die Anordnung ferner wenigstens eine zusätzliche Windung umfasst, die außerhalb des ersten Satzes von Windungen angeordnet ist, wobei die wenigstens eine zusätzliche Windung zu einem Bezugspotential kurzgeschlossen ist.

In einer weiteren Ausführungsform ist wenigstens eine Sensorspule eine Mehrebenen-Sensorspule.

In einer besonders bevorzugten Ausführung umfasst die Anordnung für einen induktiven Sensortastschalter: einen Benutzerschnittstelle-Frontplattenabschnit; eine Sensorspule, die auf einer ersten Leiterplatte angeordnet ist; ein leitendes Target, das zwischen dem Benutzerschnittstelle-Frontplattenabschnitt und der Sensorspule angeordnet ist; eine zweite Leiterplatte, die zwischen der ersten Leiterplatte mit der Sensorspule und dem Benutzerschnittstelle-Frontplattenabschnitt angeordnet ist; einen Rahmen, der zwischen der zweiten Leiterplatte und dem Benutzerschnittstelle-Frontplattenabschnitt angeordnet ist, wobei der Rahmen einen Überbrückungsabschnitt umfasst, der eine oberste Oberfläche, die zu einer unteren Oberfläche des Benutzerschnittstelle-Frontplattenabschnitts benachbart ist, und eine unterste Oberfläche, die der obersten Oberfläche der Leiterplatte zugewandt ist, besitzt, wobei der Rahmen ferner einen Wulstabschnitt umfasst, der von der untersten Oberfläche des Überbrückungsabschnitts herab steht, wobei der ferne Abschnitt des Wulstabschnitts zu einem Abschnitt der obersten Oberfläche der zweiten Leiterplatte benachbart oder mit diesem in Verbindung stehend angeordnet ist und wobei das leitende Target auf einem Abschnitt einer tieferen Oberfläche der zweiten Leiterplatte unter dem Wulstabschnitt angeordnet ist, so dass eine Durchbiegung des Benutzerschnittstelle-Frontplattenabschnitts über dem Rahmen zu einer Durchbiegung des Überbrückungsabschnitts führt, deren Kraft durch den Wulstabschnitt auf die zweite Leiterplatte übertragen wird, womit die zweite Leiterplatte durchgebogen wird und die Kopplung des leitenden Targets mit der Sensorspule verändert wird.

Vorteilhafter Weise ist jede der mehreren Treiberschaltungen lokal zu jener Anordnung für den induktiven Sensortastschalter, zu der sie einen Treiberstrom liefert, auf der Leiterplatte angeordnet.

Zweckmäßiger Weise umfasst wenigstens eine der mehreren Anordnung für einen induktiven Sensortastschalter einen Frontplattenabschnitt, wobei das leitende Target zur Sensorspule der wenigstens einen Anordnung für einen induktiven Sensortastschalter benachbart, jedoch von dieser beabstandet angeordnet ist, wobei die Sensorspule auf einer Leiterplatte angeordnet ist.

In einer weiteren Ausgestaltung ist eine zweite Leiterplatte zwischen der Leiterplatte mit der Sensorspule und dem Frontplattenabschnitt und ein Rahmen zwischen der zweiten Leiterplatte und dem Frontplattenabschnitt angeordnet.

Vorteilhafter Weise umfasst der Rahmen einen Überbrückungsabschnitt, der eine oberste Oberfläche, die zu einer unteren Oberfläche des Frontplattenabschnitts benachbart ist, und eine unterste Oberfläche, die der zweiten Leiterplatte zugewandt ist, aufweist.

In einer besonders vorteilhaften Weiterbildung umfasst der Rahmen einen Wulstabschnitt, der von der untersten Oberfläche des Überbrückungsabschnitts herab steht, wobei der ferne Abschnitt des Wulstabschnitts zu einem Abschnitt einer vorderen Oberfläche der zweiten Leiterplatte benachbart oder mit diesem in Verbindung stehend angeordnet ist.

In einer bevorzugten Alternative ist das leitende Target an einem Abschnitt einer hinteren Oberfläche der zweiten Leiterplatte unter dem Wulstabschnitt angeordnet, so dass eine Durchbiegung des Frontplattenabschnitts über dem Rahmen zu einer Durchbiegung des Überbrückungsabschnitts führt, deren Kraft durch den Wulstabschnitt auf die zweite Leiterplatte übertragbar ist, womit die zweite Leiterplatte durchbiegbar ist und die Kopplung des leitenden Targets mit der Sensorspule veränderbar ist.

In einer weiteren Ausführungsform umfasst jede Anordnung für die induktive Sensortaste ein lichtdurchlässiges Tastenelement, das durch einen Rahmen unterstützt ist, wobei das Target auf einer rückwärtigen Außenfläche des lichtdurchlässigen Tastenelements angeordnet ist.

In einer besonderen Ausführungsform der Erfindung wird ein verbesserter induktiver Sensortastschalter geschaffen. In einer weiteren Ausführungsform der Erfindung wird eine Schaltung für induktiven Sensortastschalter geschaffen, die die Referenzdrosselspule erübrigt, ohne die Hinzufügung umfangreicher Software zu erfordern.

Die vorliegende Erfindung bezieht sich auf einen induktiven Sensortastschalter und seine zugeordnete Steuerschaltung, wobei die Benutzerschnittstelle für induktiven Sensortastschalter zur Verwendung mit einer Steuerschaltung geeignet ist, die Treiberelemente besitzt, die dem jeweiligen Tastenschalter örtlich zugeordnet sind.

Obwohl die Erfindung hier als in einer Anordnung und einer Schaltung für induktiven Sensortastschalter konkretisiert veranschaulicht und beschrieben wird, soll sie dennoch nicht auf die gezeigten Details beschränkt sein, da daran ohne Abweichung vom Leitgedanken der Erfindung und im Umfang und Bereich von Entsprechungen der Ansprüche liegend verschiedene Modifikationen und konstruktive Veränderungen vorgenommen werden können.

Die Konstruktion der Erfindung wird jedoch zusammen mit ihren weiteren Aufgaben und Vorteilen aus der folgenden Beschreibung der spezifischen Ausführungsformen am Besten verstanden, wenn sie in Verbindung mit den begleitenden Zeichnungen gelesen wird.

Mehrere Ausführungsbeispiele werden anhand der Zeichnung und anhand der nachstehenden Beschreibung näher erläutert. Es zeigen:
- Fig. 1: eine Querschnittsansicht einer Anordnung für einen induktiven Tast- bzw. Berührungssensor in Übereinstimmung mit dem Stand der Technik,
- Fig. 2: ein Blockschaltplan einer induktiven Tastschaltung in Übereinstimmung mit dem Stand der Technik,
- Fig. 3: einen Schaltplan einer Schaltung für einen induktiven Sensortastschalter in Übereinstimmung mit einer besonderen Ausführungsform der vorliegenden Erfindung,
- Fig. 4: eine Querschnittsansicht einer Anordnung für einen induktiven Sensortastschalter in Übereinstimmung mit einer besonderen Ausführungsform der vorliegenden Erfindung,
- Fig. 5-7: Querschnittsansichten einer Anordnung für einen induktiven Sensortastschalter in Übereinstimmung mit anderen besonderen Ausführungsformen der vorliegenden Erfindung,
- Fig. 8A: eine isometrische Ansicht einer Scheibe, die als Target verwendet wird, in Übereinstimmung mit einer besonderen Ausführungsform der vorliegenden Erfindung,
- Fig. 8B: eine Seitenrissansicht der Scheibe von Fig. 8A,
- Fig. 9A: eine isometrische Ansicht einer mit Füßen versehenen Scheibe, die als Target verwendet wird, in Übereinstimmung mit einer besonderen Ausführungsform der vorliegenden Erfindung,
- Fig.9B: eine Seitenrissansicht der mit Füßen versehenen Scheibe von Fig. 9A,
- Fig. 10: eine Ansicht eines hauben- oder kappenförmigen Targets in Übereinstimmung mit einer weiteren Ausführungsform der vorliegenden Erfindung,
- Fig. 11: eine isometrische Ansicht eines rechtwinkligen Targets in Übereinstimmung mit einer weiteren Ausführungsform der vorliegenden Erfindung,
- Fig. 12-15: Querschnittsansichten einer Anordnung für induktiven Sensortastschalter in Übereinstimmung mit weiteren Ausführungsformen der vorliegenden Erfindung,
- Fig. 16: eine Draufsicht einer besonderen Ausführungsform eines mehrblättrigen Targets in Übereinstimmung mit einer weiteren Ausführungsform der vorliegenden Erfindung,
- Fig. 17: eine Draufsicht der Metallablagerungsschicht einer Sensorspule in Übereinstimmung mit einer besonderen Ausführungsform der vorliegenden Erfindung,
- Fig. 18: eine perspektivische, auseinander gezogene Ansicht der Metallablagerungsschichten einer Spule in mehreren Ebenen in Übereinstimmung mit einer besonderen Ausführungsform der Erfindung,
- Fig. 19A: eine teilweise, abgeschnittene Seitenrissansicht einer induktiven Tast- bzw. Berührungstastatur in Übereinstimmung mit einer besonderen Ausführungsform der Erfindung;
- Fig. 19B: eine teilweise, auseinander gezogene Ansicht eines Abschnitts der Tastatur von Fig. 19A,
- Fig. 20A: eine von oben aufgenommene, perspektivische Ansicht einer besonderen Ausführungsform eines Rahmens zur Verwendung in der Tastatur von Fig. 19A,
- Fig. 20B: eine vergrößerte, teilweise Draufsicht eines Rahmens, der Tastschalterelemente enthält, in Übereinstimmung mit einer besonderen Ausführungsform,
- Fig. 21A: eine Draufsicht eines Tastschalterelements in Übereinstimmung mit einer besonderen Ausführungsform der Erfindung,
- Fig. 21B: eine von oben aufgenommene, perspektivische Ansicht des Tastschalterelements von Fig. 21A,
- Fig. 21C: eine von unten aufgenommene, perspektivische Ansicht Tastschalterelements aus den Fig. 21A und 21 B und
- Fig. 22: eine Draufsicht einer möglichen PCB-Auslegung für jede Anordnung für induktiven Sensortastschalter in Übereinstimmung mit einer besonderen Ausführungsform der vorliegenden Erfindung.

Hier werden eine Anordnung und eine Schaltung für induktiven Sensortastschalter geschaffen, die unter bestimmten Umständen dazu verwendet werden können, sowohl die Signalstärke als auch die Rauschunempfindlichkeit der vorliegenden Erfindung gegenüber jenen des MICROCHIP-Entwurfs zu verbessern.

Insbesondere ist in Fig. 2 ein Blockschaltplan eines Systems 20 für induktiven Sensortastschalter des Standes der Technik in Übereinstimmung mit den Lehren des MICROCHIP-Entwurfs gezeigt. Um die Impedanz einer jeweiligen Sensor- oder Messspule 26 zu messen, erzeugt das System 20 einen Impuls am Impulsbreitenmodulator (PWM) 22, der durch den Treiber 24 in einen Treiberimpuls umgesetzt wird, der dazu verwendet wird, wiederum eine jeweilige Sensorspule 26 zu erregen. Dies erzeugt eine Impusspannung an der erregten Sensorspule 26, die sowohl zum Strom als auch zur Impedanz der Spule 26 proportional ist. Die Impulsspannung von der Sensorspule 26 wird weiter verarbeitet und analysiert, um zu ermitteln, ob sich eine Veränderung der Impedanz ergeben hat, die eine Berührung durch den Benutzer anzeigt. Wie in Fig. 2 gezeigt ist, sind die Sensorspulen 26 jeweils an einem Ende über eine einzige gemeinsame Verbindung mit einer Referenzspule 28 verbunden. Wie oben beschrieben worden ist, erzwingt die Verbindung mit einer solchen Referenzspule die Schaffung langer Pfade in der PCB-Auslegung, die speziell bei langen Tastaturen das Rauschen aufnehmen und die Signalstärke verringern.

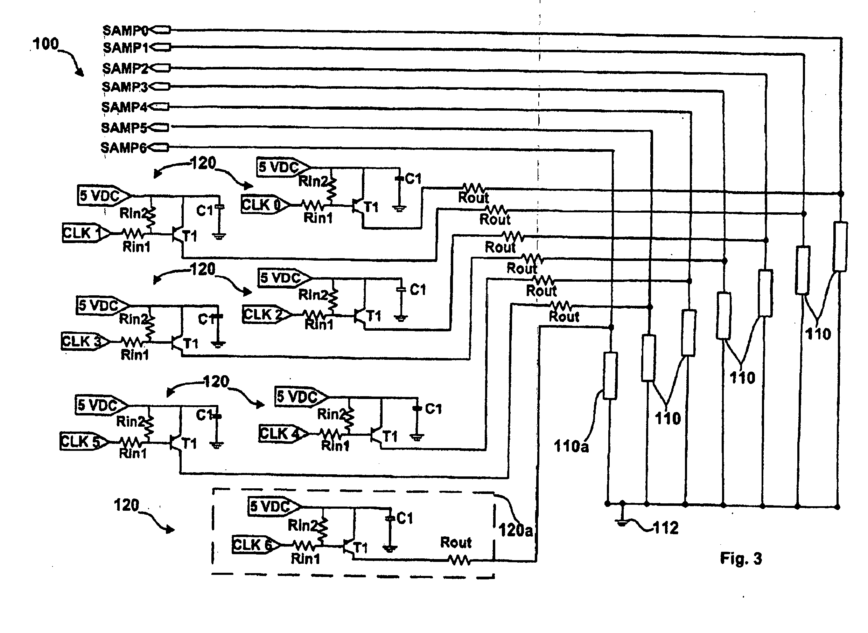

In Fig. 3 ist nun eine besondere Ausführungsform einer Schaltung 100 für induktiven Sensortastschalter der vorliegenden Erfindung gezeigt, die für eine verbesserte Rauschunempfindlichkeit und eine verbesserte Signalstärkenübertragung sorgt. Insbesondere ist die Anzahl langer, verrauschter Pfade, die dem System des Standes der Technik zueigen ist, stark verringert. Wie aus der Schaltung von Fig. 3 ersichtlich ist, ist jede der Sensorspulen 110 des Systems 100 an der gemeinsamen Verbindung direkt (d. h. nicht über irgendein anderes in Reihe geschaltetes Schaltungselement) mit Erde 112 und nicht mit einer Referenzspule verbunden, womit es sich erübrigt, von jeder Sensorspule ein Pfad zu einer gemeinsamen Referenzspule zu ziehen. Somit geht keine Energie zur Referenzspule, wodurch die Verhältnisänderung, wenn ein Tastendrücken erfasst wird, verringert wird. Nach Bedarf wird in einer besonderen Ausführungsform der Erfindung anstelle der weggelassenen Referenzspule ein Software-Filtern zum Kompensieren der Drift hinzugefügt.

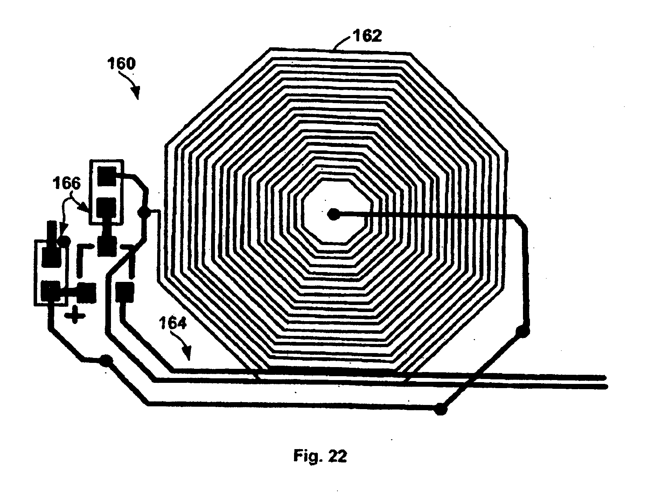

Ferner beseitigt die Schaltung 100 auch lange Pfade von einer gemeinsamen Treiberschaltung zu jeder Sensorspule 110, indem zum Erregen der jeweiligen Spulen 110 individuelle Treib- oder Treiberschaltungen 120 vorgesehen sind. Genauer ist jede der Treiberschaltungen 120 lokal (d. h. in nächster Nähe) zur Sensorspule 110, die sie treibt, vorgesehen. Beispielsweise ist die Treiberschaltung 120a in der Nähe der Sensorspule 110a auf der PCB angeordnet. Ähnlich befinden sich die übrigen einzelnen Treiberschaltungen 120 auf der Leiterplatte (PCB) in der Nähe der jeweils mit ihr verbundenen Sensorspule 110, die durch die einzelne Treiberschaltung 120 getrieben wird. Beispielsweise zeigt Fig. 22 eine repräsentative Metallschicht 160 einer PCB-Auslegung in Übereinstimmung mit einer besonderen Ausführungsform der vorliegenden Erfindung. Bei der Metallschicht 162 ist das die Sensorspule 162 bildende Metall nächstgelegen zu den Metallspuren 166 und Kontakten oder Pads 164 für die Elemente der Treiberschaltung (d. h. einen Treibertransistor, einen oder mehrere Eingangswiderstände, einen oder mehrere Ausgangswiderstände usw.) auf die PCB gelegt. Insbesondere ist für jede Sensorspule 162 einer Tastatur die Metallisierung für die Kontakte für die jener Sensorspule 162 zugeordneten Treiberschaltung höchstens einige Millimeter von der äußersten Windung der Sensorspule 162 entfernt angeordnet, was somit die Zuleitungslängen zwischen einer Treiberschaltung und der Sensorspule 162, die sie treibt, verkürzen kann.

Wie in Fig. 3 gezeigt ist, umfasst jede der mehreren Treiberschaltungen 120 ihren eigenen Treibertransistor T1 und Widerstands- und Kondensatorelemente, die dazu verwendet werden, den Treiberstrom zu definieren. In einer besonderen Ausführungsform der Erfindung umfasst jede der Treiberschaltungen 120 wenigstens einen Treibertransistor T1, einen zwischen die Basis des Transistors T1 und einen Takteingang für die jeweilige Treiberschaltung 120 geschalteten ersten Eingangswiderstand Rin1, einen zwischen die Basis von T1 und eine Gleichstrom-Leistungsversorgung geschalteten zweiten Eingangswiderstand Rin2, einen Ausgangswiderstand Rout und einen Kondensator C1. Lediglich als Beispiel beträgt in einer besonderen Ausführungsform der Erfindung Rin1 470 Ohm, Rin2 100 Ohm, Rout 270 Ohm, C1 1 µF und die Leistungsversorgung 5 Volt Gleichstrom. Der Wert der Drosselspulen 110 wird auf Grundlage mehrerer Faktoren, die den Außenradius der Spule, die Anzahl von Windungen in der Spule und die Tiefe der Spule umfassen, gewählt. Jede Sensorspule 110 wird über einen in Fig.3 gezeigten Abtastausgang durch einen Mikrocontroller oder Mikroprozessor (nicht gezeigt) periodisch abgetastet. Es sei angemerkt, dass, obwohl der Transistor T1 als pnp-Transistor gezeigt ist, dies nicht einschränkend auszulegen ist, da die Schaltung an die Verwendung eines npn-Transistors angepasst werden kann.

Wie in Fig.3 gezeigt ist, wird jede Sensorspule 110 dieser Ausführungsform durch lediglich eine Treiberschaltung 120 getrieben, wobei umgekehrt jede Treiberschaltung 120 lediglich eine zugeordnete Sensorspule 110 treibt. Dies beseitigt die Notwendigkeit, höhere Ströme durch die gesamte PCB (d. h. von einer zentralen, gemeinsamen Treiberschaltung zu jeder einzelnen Sensorspule) zu leiten. Die ortsbezogene Anordnung einer jeden einer Vielzahl von Treiberschaltungen zu ihrer einen zugeordneten Sensorspule führt zu einem kleinen Stromkreis durch die Sensorspule jeder Tastenanordnung ohne größeres Abstrahlen von Strom/Rauschen von der Spule nach außen. Je weniger Strom/Rauschen von der Spule nach außen abgestrahlt wird, desto weniger kann somit von anderen Sensorspulen aufgenommen werden. Das Beseitigen der Referenzspule und das örtliche Versetzen jeder Treiberschaltung zu ihrer Spulen-/Tastenanordnung ermöglicht eine bessere Nutzung des Messstroms und der Messenergie sowie das Kleinermachen der Schleifenfläche, um die Aufnahme von externen Rauschfeldern (da jede Spule als Antenne für externe Felder wirken kann) zu reduzieren. Diese Schaltungsveränderungen führen zu weniger durch die gesamte PCB geleitete Verbindungen. Da Tastaturen für Geräte zumeist räumlich beschränkt sind, trägt dies auch dazu bei, ihren Umfang zu reduzieren, und ermöglicht die Fertigung der Anordnung unter Verwendung weniger Schichten im PCB-Entwurf als bei herkömmlichen Anordnungen. Im Ergebnis reduziert dies die Kosten zum Herstellen der Anordnung.

Da bei der oben beschriebenen Ausführungsform der vorliegenden Erfindung nahezu sämtliche externe Felder ein einheitliches Feld bilden, das der einzelnen Spulen-/Tastenanordnung örtlich zugeordnet ist, kann die Rauschaufnahme durch die Spule weiter reduziert werden, indem in der PCB-Folie eine verkürzte Windung außerhalb der Spule hinzugefügt wird. Dies reduziert gegebenenfalls etwas die Signalstärke; da sie sich jedoch außerhalb der Spulenfläche befindet und das spuleninduzierte Feld in der Nähe des Spulenmusters konzentriert ist, verursacht es keine große Verringerung der Signalstärke. Die verkürzte Windung reduziert jedoch einheitliche externe Felder, da diese von außerhalb des Spulenmusters kommen.

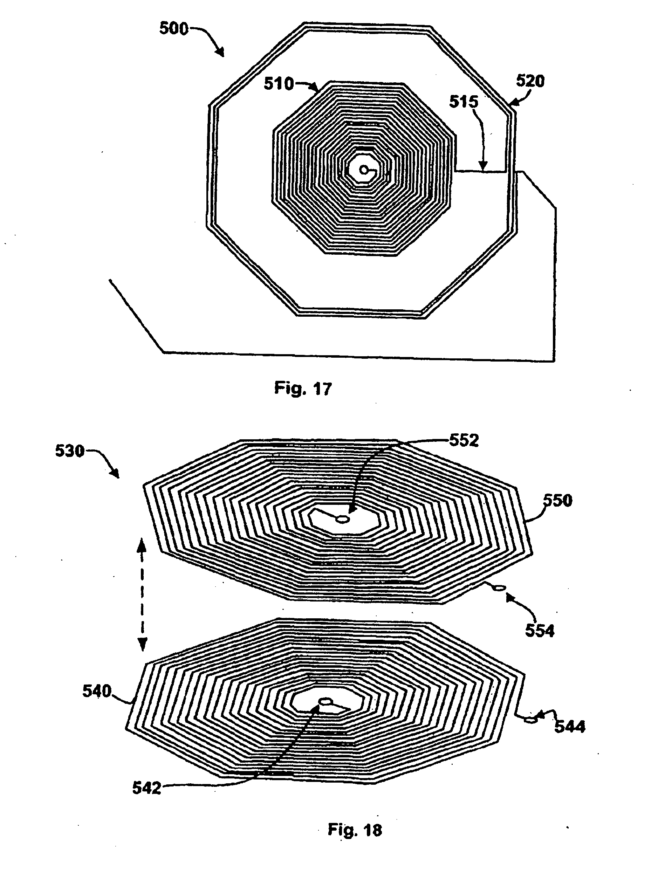

Außerdem kann nach Bedarf die Rauschaufnahme durch die Sensorspule weiter reduziert werden, indem Windungen außerhalb der Sensorspule als Erweiterung der Sensorspule, jedoch in umgekehrter Richtung, hinzugefügt werden. Siehe beispielsweise Fig.17, wo die Windungen 510 der Sensorspule 500 in einer ersten Richtung drehen, jedoch anders herum am Windungsabschnitt 515, um mehrere Windungen 520 in der Gegenrichtung zu haben. Die Verwendung solcher zusätzlichen Windungen 520 reduziert die Feldstärke derart, dass gegenüber externen Feldern die Schleifenfläche der Sensorspule abzüglich der Schleifenfläche der Windungen in Gegenrichtung zu einer Aufnahme durch (N Spulen - x Rückwärtswindungen)² führt. Es sei angemerkt, dass nur wenige große gegenläufige Windungen der Schleifenfläche vieler kleiner Windungen in der Spule gleichkommen.

In Fig. 18 ist nun eine weitere Ausführungsform einer Mehrebenen- oder Mehrschicht-Sensorspule 530, die als Sensorspule in einem System in Übereinstimmung mit der vorliegenden Erfindung verwendet werden kann, gezeigt. Insbesondere umfasst die Mehrschicht-Sensorspule 530 zwei einzelne Sensorspulen 540, 550, die auf der Oberfläche der PCB (nicht gezeigt) einander überdecken und sich die gemeinsam verbundenen Eingangs- bzw. Ausgangskontakte 542, 552 und 544, 554 teilen. Insbesondere ist die Spule 550 in einer Richtung gewickelt, die zu jener der Spule 540 entgegengesetzt ist, und überdeckt die Spule 540 auf der PCB. Beide Eingangskontakte 542 sind mit einem Messeingang (beispielsweise in Fig. 3 gezeigt) eines Mikrocontrollers oder Mikroprozessors (nicht gezeigt) verbunden, der für die Auswertung der an der Sensorspule 530 vorgenommenen Messungen programmiert ist. Die Ausgangskontakte 544 und 554 sind mit einem gemeinsamen Bezugspotential wie etwa Erde verbunden. Die Mehrschichtspule sorgt für eine größere Feldstärke und bessere Wirbelströme, die beim Eintreten einer Bewegung des Targets zu einem besseren Signalrücklauf führen. Die PCB kann ferner versetzte Durchkontaktierungen umfassen, um blinde Durchkontaktierungen zu vermeiden und dazu beizutragen, die Kosten niedrig zu halten. Es sei angemerkt, dass, obwohl in der erläuternden Darstellung von Fig. 18 zwei Spulen gezeigt sind, dies nicht einschränkend auszulegen ist, da nach Bedarf auch mehr Spulenschichten vorgesehen sein können. Jedoch verringert wohlgemerkt das Vergrößern der Anzahl von Spulenschichten bei der Sensorspule 530 aufgrund der vergrößerten Dicke der Schichten auf der PCB den Abstand zwischen der obersten Oberfläche der Sensorspule 530 und dem Targetabschnitt des Tastschalters entsprechend. Um die vergrößerte Schichtenhöhe an der PCB unterzubringen, kann nach Bedarf ein entsprechender Abgleich an den Abstand zwischen der obersten Spulenschicht und dem Target vorgenommen werden.

Ein weiterer Nutzen des örtlichen Zuordnens der Treiberschaltungen ist der, dass die Treiberschaltungen 120 nach Bedarf so konfiguriert werden können, dass Abweichungen in der Treiberstärke von Taste zu Taste möglich sind. Beispielsweise können unterschiedlich bemessene Tasten (und deren zugeordnete Spulen) unterschiedliche Signalstärkepegel benötigen. Die Treiberspannung kann von einer Sensorspulen/Sensortastenanordinung zur anderen um einen festen Wert verändert werden. Alternativ kann nach Bedarf die Treiberspannung von einem Sensor zum anderen als Software-Variable mittels eines adaptiven Algorithmus verändert werden.

Ein weiterer Vorteil der Zuordnung des Treibers 120 zum Ort der zugeordneten Sensorspule 110, ist der, dass die Verzögerung des Treiberimpulses so optimiert werden kann, dass, verglichen mit einem synchronen Detektorsystem, alle nützlichen Signale in den Detektor geholt werden. Insbesondere kann die Verzögerung stark verbessert werden, indem der Treibertransistor und der Messwiderstand an den Spulenort versetzt werden, da frühere Treiberimpulsverzögerungszeiten durch Temperaturschwankung und Teileabweichung beeinflusst waren.

Außerdem wurde in einer besonderen Ausführungsform der Erfindung das Rauschen weiter reduziert, indem beim PCB-Entwurf Spulenschichten hinzugefügt wurden. Beispielsweise können in Übereinstimmung mit der vorliegenden Ausführungsform Spulen in doppelseitigen PCB gestapelt sein. In einer sehr speziellen Ausführungsform wurden bei einer vierschichtigen PCB vier Spulenschichten gestapelt, indem die Durchkontaktierung versetzt wurde, um versteckte Durchkontaktierungen zu vermeiden.

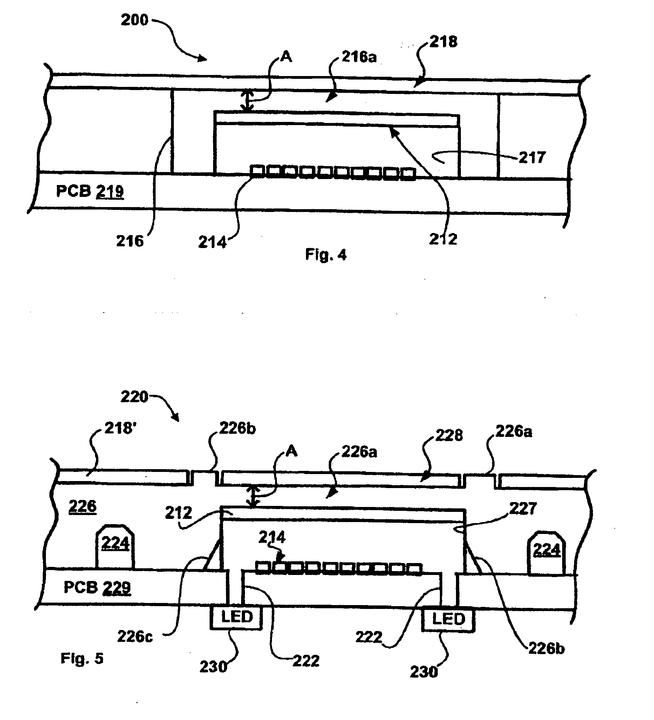

Mit Bezug auf Fig.4 wird nun eine Anordnung 200 für induktiven Sensortastschalter beschrieben, die in einem System für induktiven Sensortastschalter in Übereinstimmung mit einer besonderen Ausführungsform der vorliegenden Erfindung für eine verbesserte Signalstärke und eine erhöhte mechanische Stabilität sorgt. Die Tastschalteranordnung 200 dieser Ausführungsform ist unter einem Abschnitt der Frontplatte oder Abdeckung 218 (d. h. der Frontplatte der Tastatur, des Produkts und/oder des Haushaltsgeräts) angeordnet, der einen Tastschalter der Benutzerschnittstelle definiert. In einem speziellen Beispiel ist die Frontplatte 218 und somit die Benutzerschnittstelle eine dünne Edelstahlplatte. Jedoch ist im Gegensatz zu der in Fig. 1 dargestellten Tastschalteranordnung des Standes der Technik das Target 212 der Tastschalteranordnung 200 nicht an die Unterseite der Abdeckung 218 geheftet bzw. geklebt, sondern stattdessen durch einen zwischen der Abdeckung 218 und der PCB 219 angeordneten Rahmen 216 unterstützt.

Der Rahmen 216 ist als Bügel oder Tasche, die einen Raum oder Hohlraum 217 um die Sensorspule 214 definiert, ausgebildet. Am stärksten bevorzugt ist der Rahmen 216 ein aus Kunststoff gefertigtes separates, eigenständiges Teil und umfasst einen die Sensorspule 214 umgebenden Abstützbügel 216, an dessen Oberseite sich ein Überbrückungsabschnitt 216a befindet, der an einem Ort, der einen Tastschalter an der Benutzerschnittstelle der Frontplatte 218 definiert, über der Sensorspule 214 und unter der Abdeckung 218, an die Unterseite der Abdeckung 218 angrenzend und in Kontakt mit dieser, verläuft. An die Unterseite des Überbrückungsabschnitts 216a ist im Hohlraum 217 über der Sensorspule 214 ein metallisches Target 212 dieser Ausführungsform geheftet. Der Abstützbügel 216 kann als Rahmen (d. h. vier Füße oder vier Wände usw.) gefertigt sein oder in Form eines Rings, der durch den Überbrückungsabschnitt 216a abgedeckt ist, vorliegen. Dieser Rahmen kann durch Schrauben, warm eingesetzte Verbinder oder andere herkömmliche Verbindungsverfahren mit der PCB 216 verbunden sein. In dieser Ausführungsform ist der Überbrückungsabschnitt 216a aus sehr dünnem Kunststoff entworfen, so dass die Durchbiegung der Abdeckung 218 zu einer Durchbiegung des Überbrückungsabschnitts 216a führt. In einem speziellen Beispiel beträgt die Dicke "A" des Überbrückungsabschnitts 216a 0,8 mm.

Auf die Durchbiegung der Abdeckung 218 und daraus resultierend des Überbrückungsabschnitts 216a hin wird auch das metallische Target 212 an der Unterseite des Überbrückungsabschnitts durchgebogen, womit sich zwischen dem Target 212 und der Sensorspule 214 verändert, was ein Drücken des Tastschalters anzeigt. Somit ist bei dieser Ausführungsform das Target 212 durch eine Struktur unterstützt, die zwischen der Frontplattenabdeckung 218 und der PCB 219 angeordnet ist, und nicht direkt an die Unterseite der Frontplattenabdeckung 218 geheftet.

Wie oben angemerkt worden ist, ist das Target 212 der Tastschalteranordnung 200 stattdessen an die Unterseite des Überbrückungsabschnitts 216a geheftet, um das Target 212 in die gewünschte Beziehung mit der Sensorspule 214 zu bringen. In einer besonderen Ausführungsform der vorliegenden Erfindung ist das Target 212 als Teil eines Heißprägeprozesses an der Unterseite des Überbrückungsabschnitts angebracht. Alternativ kann nach Bedarf das Target 212 durch Drucken des Targets direkt auf die Rückseite der Abdeckung, um eine Metalloberfläche über der Sensorspule zu schaffen, an der Unterseite des Überbrückungsabschnitts 216a angebracht sein. Beispielsweise kann in Übereinstimmung mit dieser Ausführungsform eine heißgeprägte Folie oder ein leitendes Druckmaterial durch einen geeigneten Prozess (d. h. Heißprägen, Drucken usw.) auf den Rahmen 216 aufgebracht sein. Das Heißprägen oder Drucken des Targets 212 auf eine Oberfläche des Rahmens 216 anstatt die Abdeckung 218 kann speziell bei Anwendungen, bei denen eine benachbarte Beleuchtung benötigt wird und/oder gekrümmte Oberflächen verwendet werden, sinnvoll sein.

In einer besonderen Ausführungsform der Erfindung definiert ein Abschnitt der Frontplatte 218 eine Benutzerschnittstelle oder Tastatur für ein Produkt oder Haushaltsgerät. Unter Anwendung eines Heißprägeprozesses wird eine Metallfolie auf die innere Oberfläche des Kunststoffbügels oder der Kunststofftasche geprägt. Bei dieser Ausführungsform besitzt die Folie wünschenswerter weise eine Dicke zwischen 0,05 mm und 0,1 mm. Somit sind bei dieser Ausführungsform die herkömmlichen PCB-basierten Tastenblöcke durch eine heißgeprägte Folie oder gedruckte leitende Schicht, die durch einen separaten Bügel unterstützt ist, ersetzt.

Alternativ, wie oben beschrieben worden ist, kann ein Druckprozess angewandt werden, um ein leitendes Material auf die Unterseite des Überbrückungsabschnitts 216a zu drucken. Die Dicke des gedruckten Materials wäre ähnlich zu jener für die heißgeprägte Folie, d. h. betrüge am stärksten bevorzugt zwischen 0,05 mm und 0,1 mm.

In Fig. 5 ist nun eine weitere Ausführungsform einer Tastschalteranordnung 220 in Übereinstimmung mit der vorliegenden Erfindung gezeigt. Die Tastschalteranordnung 220 gleicht der Tastschalteranordnung 200 von Fig.4, jedoch ist sie auf eine Benutzerschnittstelle gerichtet, die Tastschalter mit irgendeiner Art Leuchtzeichen wie etwa Worten, Lichtringen und/oder anderen Leuchtanzeigen besitzen, jedoch eine undurchsichtige Platte aufweisen. Die Tastschalteranordnung 220 umfasst ein Target 212, das am Überbrückungsabschnitt 226a eines Rahmens 226 in einer bestimmten Ebene in Bezug auf eine Sensorspule 214 angebracht ist. Wie bei der vorherigen Ausführungsform führt die Durchbiegung der Tastschalterabdeckung 228 zur Durchbiegung des Brückenabschnitts 226a, die die Kopplung zwischen dem Target 212 und der Sensorspule 214 verändert, womit ein Tastendrücken der Tastschalterabdeckung 228 angezeigt wird. Jedoch ist bei dieser Ausführungsform der Rahmen 226 dieser Ausführungsform aus einem klaren oder anderen lichtdurchlässigen Kunststoff gefertigt, so dass von einer Lichtquelle ausgesendetes Licht auf den Ring, die Worte oder die Zeichen auf der Benutzerschnittstelle übertragen werden kann. Obwohl in Verbindung mit der vorliegenden Erfindung jeder geeignete Typ von Lichtquelle (d. h. Glühlampe, Elektrolumineszenzquelle usw.) verwendet werden kann, umfasst bei einer bevorzugten Ausführungsform die Lichtquelle an der Unterseite der PCB 229 angebrachte Lichtemitterdioden (LEDs) 230).

In einer in Fig. 5 gezeigten besonderen Ausführungsform der Erfindung umfasst der Kunststoffrahmen einen lichtdurchlässigen Ringabschnitt 226b, der eine undurchsichtige Tastschalterabdeckung 228 umgibt. Alternativ oder zusätzlich dazu kann die Tastschalterabdeckung 228 selbst gestanzte Abschnitte wie etwa Worte oder andere Zeichen besitzen, die dazu gedacht sind, beleuchtet zu werden. Licht, das durch die LEDs 230 emittiert wird, wird dazu verwendet, den Ring und/oder die Zeichen wie folgt zu beleuchten. Das Licht von den LEDs 230 geht durch Löcher 222 in der PCB 229, die zu der Licht emittierenden Seite der LEDs benachbart angeordnet sind, durch die PCB 229 hindurch. Die Löcher 222 münden in den im Rahmen zwischen dem Target 212 und der Sensorspule 214 gebildeten Hohlraum 227. Das direkt in den Hohlraum 227 emittierte Licht sowie jenes Licht, das vom Metalltarget 212 reflektiert wird, wird durch den Rahmen 226 auf die Leuchtringabschnitte 226b des Rahmens 226 und/oder auf irgendwelche Zeichen oder Worte auf der Abdeckung 228 und/oder der Frontplatte 218' übertragen. Nach Bedarf kann der Rahmen 226 optional Facetten 226c aufweisen, die insbesondere so angeordnet sind, dass sie Licht, das durch die LEDs 230 emittiert wird, in den Hohlraum 227 auf die Lichtringabschnitte 226b lenken und konzentrieren. Außerdem kann der Rahmen 226 nach Bedarf undurchsichtige oder lichtundurchlässige Abschnitte 224 umfassen, um das in Verbindung mit einer Tastschalteranordnung emittierte Licht daran zu hindern, auf eine andere Tastschalteranordnung übertragen zu werden. In einer besonderen Ausführungsform der vorliegenden Erfindung ist auf die im Hohlraum 227 angeordnete PCB 226 ein weißer Überzug aufgebracht, um Licht vom Hohlraum 227 noch stärker in den lichtdurchlässigen Rahmen 226 zu reflektieren.

Wie bei der Tastschalteranordnung 200 kann das Target 212 der Tastschalteranordnung 220 auf verschiedene Art und Weise einschließlich, jedoch nicht darauf beschränkt, durch Heißprägen des Targets 212 auf den Rahmen 226 und/oder Drucken des Targets 212 auf den Rahmen 226 unter Verwendung einer leitenden Tinte am Rahmen 226 angebracht sein. Es sei angemerkt, dass nach Bedarf das Target 212 auch als Metallscheibe oder -folie ausgebildet sein kann, die an der Unterseite des Überbrückungsabschnitts 226a haftend angebracht ist, ohne vom Leitgedanken der vorliegenden Erfindung abzuweichen.

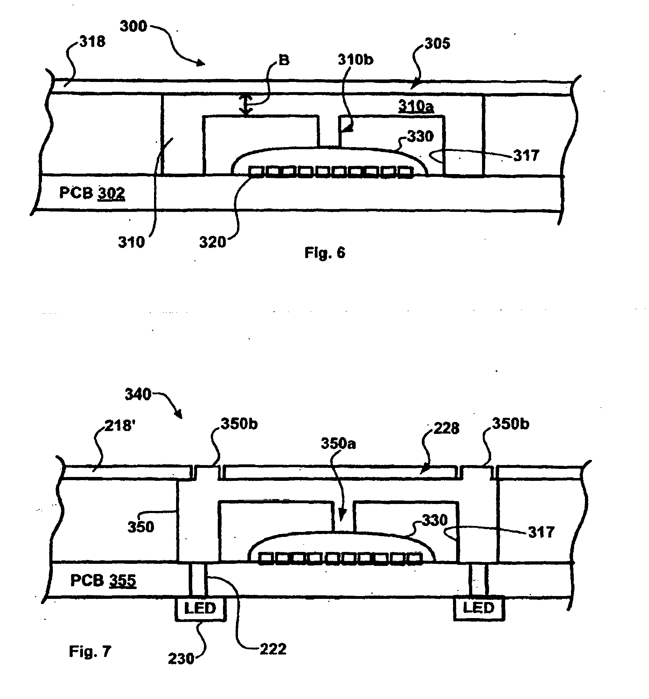

In Fig. 6 ist nun eine weitere Ausführungsform einer Tastschalteranordnung 300 für einen induktiven Sensortastschalter in Übereinstimmung mit der vorliegenden Erfindung gezeigt. Die Tastschalteranordnung 300 umfasst einen zwischen der PCB 302 und der Frontplatte 318 der Benutzerschnittstelle eines Gerätes angeordneten Rahmen 310, der dem in Verbindung mit Fig. 4 beschriebenen Rahmen 216 gleicht. Der Rahmen 310 der Anordnung 300 umfasst einen Überbrückungsabschnitt 310a, der an einem Ort, der einen Tastschalter auf der Frontplatte 318 definiert, zur Unterseite der Frontplatte 318 benachbart und in Kontakt mit dieser angeordnet ist. Der Überbrückungsabschnitt ist vorzugsweise aus einem dünnen Kunststoffmaterial gefertigt, das eine Dicke "B" besitzt, die es erlaubt, ihn als Reaktion auf die Durchbiegung der Frontplatte 318 durchzubiegen. In einer besonderen Ausführungsform beträgt die Abmessung "B" 0,8 mm.

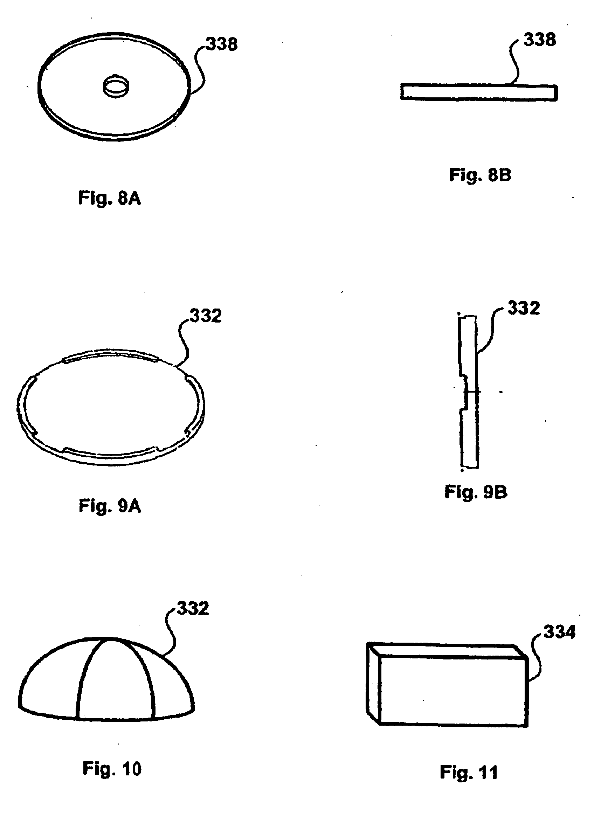

Der Rahmen 310 umfasst außerdem einen Schubstift oder Wulst 310b, der sich von der Mitte des Überbrückungsabschnitts 310a zur Sensorspule 320 hin erstreckt. Bei dieser Ausführungsform der Erfindung steht das Target 330 mit dem fernen Ende des Wulstes 310b in Verbindung und besitzt einen Umfang, der größer ist als der Umfang der Sensorspule 320, so dass er die Sensorspule 320 umschreibt. Wie ersichtlich ist, bewirkt eine Durchbiegung der Frontplatte 318 über dem Überbrückungsabschnitt 310a, dass der Schubstift 310b einen Abschnitt des Targets 330 schiebt, somit das Target 330 durchbiegt und die Kopplung zwischen dem Target 330 und der Sensorspule 320 verändert, was ein Drücken des Tastschalters anzeigt. Bei der Ausführungsform nach Fig. 6 ist das Target 330 als haubenförmige Kappe, die in Fig. 10 deutlicher gezeigt ist, ausgebildet.

Es sei angemerkt, dass in Verbindung mit dem Rahmen 310 andere Formeln eines Targets verwendet werden können, um dieselben Ergebnisse zu erzielen. Beispielsweise zeigen die Fig. 9A - 9B eine mit Füßen versehene "Scheibe" 332, die anstelle des Targets 330 von Fig. 6 an der PCB 302 oberflächenmontiert (über die sich erstreckenden Fußabschnitte) sein kann, wobei die Durchbiegung der Frontplatte 318 über dem Rahmen 310 verursacht, dass der Wulst 310b die mit Füßen versehene Scheibe 332 durchbiegt und somit die Kopplung zwischen dem Target 332 und der Sensorspule 320 verändert, was anzeigt, dass ein Tastschalterdrücken erfolgt ist. Die mit Füßen versehene Scheibe 332 aus den Fig. 9A und 9B kann durch chemisches Ätzen und/oder Prägen des als Target zu verwendenden Metalls gebildet sein.

Ähnlich kann, um nun auf die Fig. 6 und 11 zu verweisen, anstelle des hauben- oder kappenförmigen Targets 330, ein Target 334 mit der Form eines Quadrats oder Rechtecks (d. h. ein "kastenförmiges" Target) über die Sensorspule 320 gesetzt sein und auf eine Durchbiegung der Frontplatte 318 über dem Rahmen 310 hin durch den Wulst 310b aktiviert werden.

In Fig. 7 ist nun eine weitere Ausführungsform einer Anordnung 340 für Sensortastschalter gezeigt, die einen Rahmen 350 verwendet, der einen Wulst 350a besitzt, um die Durchbiegung der Tastschalterabdeckung 228 auf das auf der Leiterplatte PCB montierte Target 330 zu übertragen, wobei Licht von einer Lichtquelle, den LEDs 230 bei dieser Ausführungsform, durch Löcher 222 in der PCB 355 geht. Bei dieser Ausführungsform ist der Rahmen 350 aus einem lichtdurchlässigen Material wie etwa einem klaren Kunststoff gefertigt. Der Rahmen 350 ist daher auf die Löcher 222 ausgerichtet, um zu bewirken, dass sich Licht von den Ringabschnitten 350b sowie durch irgendwelche in die Tastschalterabdeckung 228 gestanzte Worte oder Zeichen zeigt. Es sei angemerkt, dass dies nicht einschränkend auszulegen ist, da in Übereinstimmung mit der vorliegenden Erfindung andere Anordnungen der LEDs, der Löcher 222 und des Rahmens 350 ausgeführt sein können. Beispielsweise können die LEDs 230 und die Löcher 222 so angeordnet sein, dass in derselben Weise, wie in Verbindung mit dem Rahmen 226 von Fig. 5 beschrieben worden ist, der zentrale Hohlraum 317 des Rahmens 350 und dadurch der Rahmen 350 und die Ringabschnitte 350b beleuchtet werden.

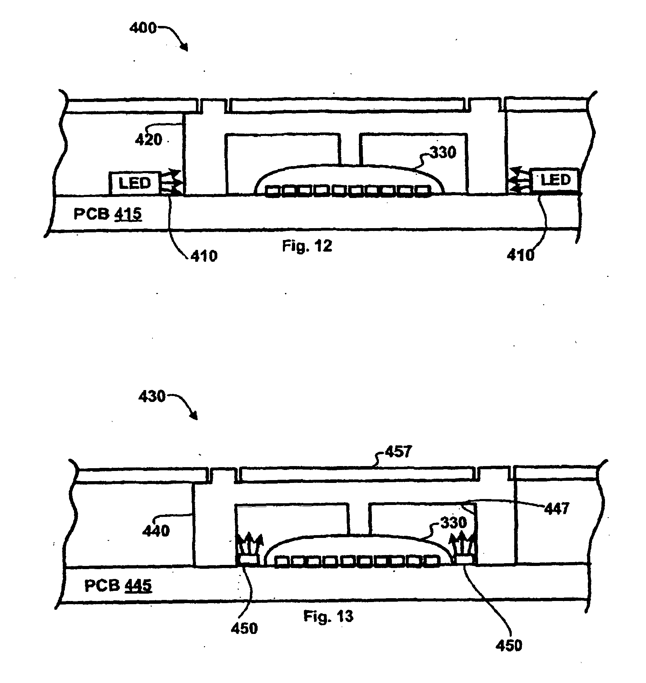

Außerdem können nach Bedarf die LEDs 330 durch LEDs ersetzt werden, die an der Vorderseite der PCB 355 montiert sind. In den Fig. 12 und 13 sind nun zwei weitere Leuchttastschalteranordnungen 400 bzw. 430 in Übereinstimmung mit weiteren Ausführungsformen der vorliegenden Erfindung gezeigt. Genauer zeigt Fig. 12 eine Tastschalteranordnung 400, bei der LEDs 410 an der Vorderseite der PCB 415 montiert sind, wobei ihre Licht emittierenden Außenflächen zu den Seitenwänden des Rahmens 420 gerichtet sind. In Fig. 13 sind die LEDs 450 an der PCB 445 im Hohlraum 447 des Rahmens 440 oberflächenmontiert, wobei ihre Licht emittierenden Außenflächen zur Frontplatte 457 gerichtet sind. Aus dem Vorhergehenden ist ersichtlich, dass in Verbindung mit einem Target in Übereinstimmung mit der vorliegenden Erfindung andere Konfigurationen einer Leuchttastschalteranordnung mittels eines lichtdurchlässigen Rahmens ausgeführt sein können.

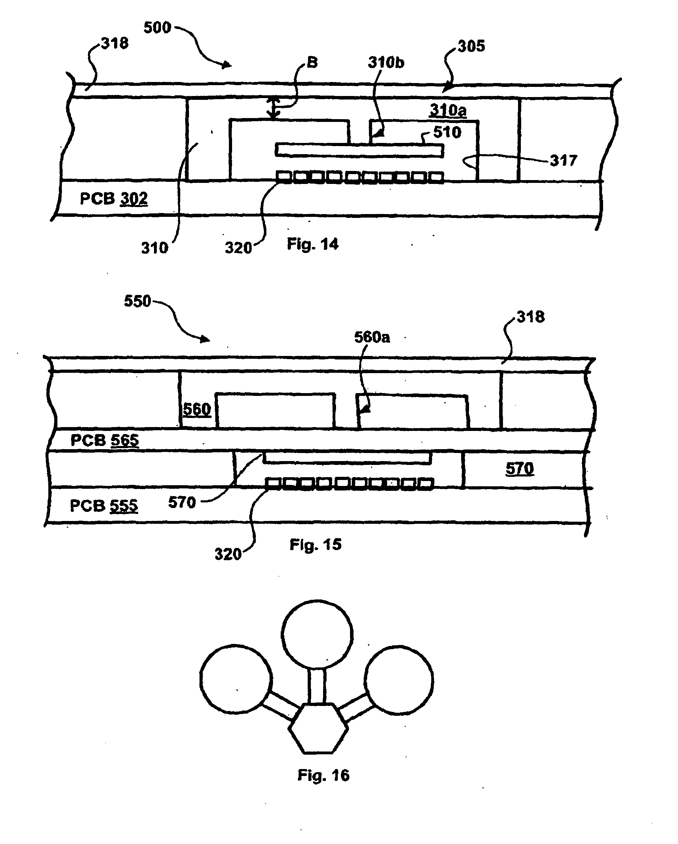

In Fig. 14 ist nun eine weitere Ausführungsform einer Tastschalteranordnung 500 in Übereinstimmung mit der vorliegenden Erfindung gezeigt. Die Tastschalteranordnung 500 gleicht in vielerlei Hinsicht der Tastschalteranordnung 300 von Fig. 6. Jedoch verwendet diese Ausführungsform, anstatt wie bei der Tastschalteranordnung 200 ein zwischen den Wulst und die PCB geschichtetes oberflächenmontiertes Target zu verwenden, ein am Wulst 310b befestigtes schwebendes Target 510. Somit bringt eine Durchbiegung des Überbrückungsabschnitts 310a, anstatt die Durchbiegung des Targets 510 zu veranlassen, das Target näher zur Sensorspule 214, womit deren Feld verändert wird und ein Tastendrücken angezeigt wird. Obwohl jedes der hier im Zusammenhang beschriebenen Targets als Target 510 verwendet werden kann, ist in einer besonders bevorzugten Ausführungsform das Target 510 eine ausgeschnittene oder ausgestanzte Scheibe wie etwa die hier in den Fig. 8A und 8B gezeigte Scheibe 338. Der Durchmesser der Scheibe 338, 510 kann nach Bedarf gewählt sein, jedoch ist er vorzugsweise gleich oder größer als der Durchmesser der Sensorspule 320. Es ist auch ersichtlich, dass in Übereinstimmung mit den Lehren hier das schwebende Target 510 von Fig. 14 in einer Leuchttastenanordnung verwendet werden kann. Beispielsweise kann das schwebende Target 510 das oberflächenmontierte Target 330 in der Tastschalteranordnung 340 von Fig. 7 oder in irgendeiner anderen hier beschriebenen Ausführungsform ersetzen.

Außerdem können in Übereinstimmung mit den in Verbindung mit Fig. 14 unterbreiteten Lehren nach Bedarf mehrere schwebende Targets mehrerer Tastschalteranordnungen unter Verwendung eines einzigen mehrblättrigen schwebenden Targets wie etwa jenes, das in Fig. 16 gezeigt ist, ausgeführt sein.

In Fig. 15 ist nun eine weitere Ausführungsform einer Anordnung 550 für induktiven Sensortastschalter in Übereinstimmung mit der vorliegenden Erfindung gezeigt. In dieser Ausführungsform ist der Rahmen 560, anstatt zwischen und in Verbindung mit der PCB 555 und der Frontplatte 318 angeordnet zu sein, zwischen einer Grundebenen-PCB 565 und der Frontplatte 318, die über der PCB 555, die die Sensorspule 320 unterstützt, angeordnet ist, angeordnet. Die Grundebenen-PCB 565 ist durch ein Distanzstück 570, das einen kreisförmigen Ausschnitt über der Sensorspule 320 aufweist, womit ein Hohlraum oder eine Kammer über der Sensorspule 320 geschaffen ist, von der PCB 555 getrennt. Der Rahmen 560 ist durch seine Außenwandabschnitte über massiven Abschnitten der Distanzstückschicht an der Grundebenen-PCB 565 abgestützt, womit der Rahmen 560 abgestützt ist, wenn ein an der Frontplatte 318 über der Anordnung 550 angezeigter Tastschalter gedrückt wird. Der Rahmen weist außerdem einen von seinem mittleren Abschnitt ausgehenden Wulst 560a auf, der mit einem Abschnitt der Grundebenen-PCB 565 in Kontakt ist. Eine Durchbiegung der Frontplatte 318 über dem Wulst 560a bewirkt, dass der Wulst 560a die PCB 565 durchbiegt. Der unter dem Wulst 560a angeordnete Abschnitt der PCB 565 umfasst ein an der Unterseite davon angeordnetes Metalltarget 570 in Nachbarschaft der Sensorspule 320. Somit wird die Durchbiegung der Frontplatte 318 durch den Rahmen 560 auf das Target 570 übertragen, was die Kopplung zwischen dem Target 570 und der Sensorspule 320 verändert, womit angezeigt wird, dass ein sich über der Anordnung an der Benutzerschnittstelle befindender Tastschalter gedrückt worden ist. In einer besonders bevorzugten Ausführungsform ist das Target 570 entweder auf die untere Oberfläche der PCB 565 gedruckt oder auf diese heißgeprägt. Es sei angemerkt, dass andere Verfahren der Aufbringung des Targets 570 auf die PCB 565 einschließlich sämtlicher Verfahren zur Schaffung einer Metallisierung einer PCB angewandt werden können.

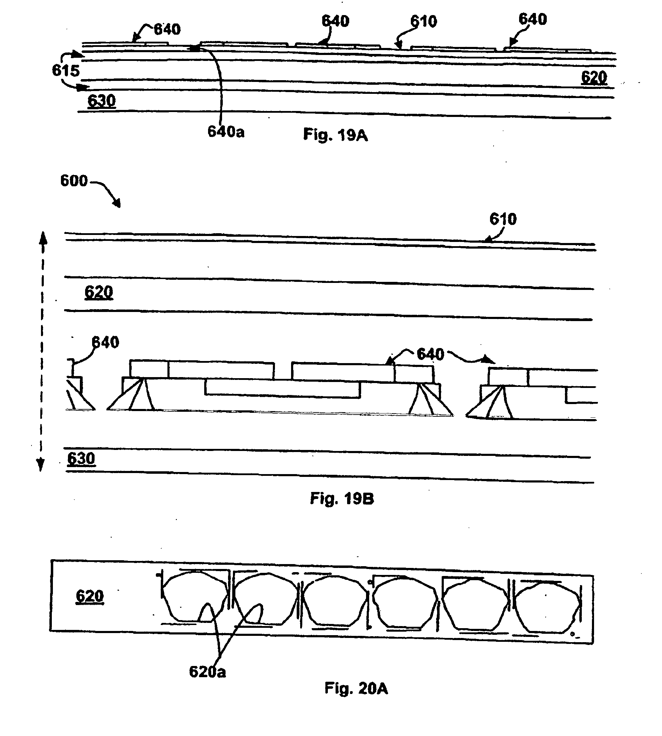

In den Fig. 19A - 21C ist eine weitere besondere Ausführungsform eines induktiven Sensortastschalters mit seiner Anordnung gezeigt, der in Verbindung mit dem System für induktiven Sensortastschalter der vorliegenden Erfindung verwendet werden kann. Insbesondere umfasst die Tastatur 600 mehrere Leuchttastschalter 640, wobei die Tastschalterelemente 640 sowohl als Lichtleiter zum Übertragen des Lichts durch die Abdeckung oder Frontplatte 610 als auch als Kraftumsetzer zum Bewegen des Targets in Bezug auf die Sensorspule dienen. Insbesondere ist ein von hinten beleuchteter Tastschalter 640 vorgesehen, der Leuchtvorwölbungen 640a aufweist, die einen Lichtring bilden und die durch Öffnungen 610a in der undurchsichtigen Frontplatte 610 gehen. Die Tastschalterelemente 640 sind in einem Rahmen 620, der zwischen der Frontplatte 610 und einer PCB 630 angeordnet ist, an Ort und Stelle gehalten. Der Rahmen 620 kann durch die zwischen dem Rahmen 620 und der PCB 630 und dem Rahmen 620 und der Frontplatte 610 angeordneten Klebe- bzw. Haftschichten 615 befestigt sein. Wie bei den vorherigen Ausführungsformen ist jeder Tastschalter über einer an der PCB 630 angeordneten entsprechenden Sensorspule im Rahmen angeordnet. Der Rahmen 620 kann nach Bedarf mittels der Ausrichtstifte 622 in Bezug auf die Frontplatte 610 ausgerichtet sein.

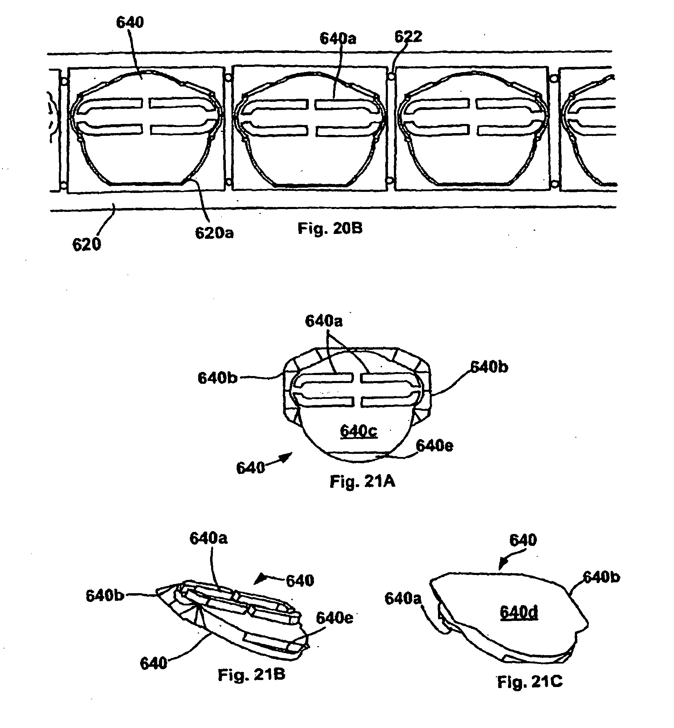

Jedes Tastschalterelement 640 ist so entworfen, dass es mit einer Öffnung 620a des Rahmens 620 zusammenpasst, wobei die Licht übertragenden Vorwölbungen 640 durch die Frontplatte 610 der Anordnung 600 gehen. Eine ebene Außenfläche 640c des Tastschalterelements 640 ist dazu vorgesehen, eine Haftschicht und/oder die Frontplatte 610 zu unterstützen. Das Tastschalterelement 640 ist durch die Nasen 640b und die Nut 640e, die die Rückseite des Rahmens 620, d. h. die von der vorderen Außenfläche 610 ferne Seite, in Eingriff nehmen, im Rahmen gehalten (wie in Fig. 20B gezeigt ist). Ein Target (in den Fig. 19 - 21 nicht gezeigt) kann durch Heißprägung, Klebung und/oder leitenden Druck direkt an der hinteren Außenfläche 640d des Tastschalterelements 640 angeordnet sein. In einer besonderen Ausführungsform ist das Target ein auf die hintere Außenfläche 640d geklebtes Stück Metallfolie.

Nach der Montage ist jedes Tastschalterelement 640 über einer Sensorspule durch den Rahmen 620 und/oder eine Haftschicht 612 (die nicht unter den Abschnitt des Tastschalterelements 640, das das Target umfasst, führt) unterstützt. Das Target an der rückwärtigen Außenfläche 640d jedes Tastschalterelements 640 ist in der gewünschten Beziehung mit einer Sensorspule angeordnet, wie anderswo hier beschrieben worden ist. Somit führt das Drücken der über einem Tastschalterelement 640 befindlichen vorderen Außenfläche oder Abdeckung zu einer Durchbiegung des Tastschalterelements 640, womit die Kopplung zwischen einem Target an der untersten Außenfläche 640d des Tastschalterelements 640 und dem Target verändert wird.

Es ist wichtig anzumerken, dass die in Verbindung mit den Fig. 4 - 7, 12 - 15 und 19 - 20 beschriebenen Tastschalteranordnungen zusammen mit der in Fig. 3 gezeigten Schaltung verwendet werden können, jedoch nicht darauf beschränkt sind. Insbesondere können auch die in Verbindung mit den Fig. 4 - 7, 12 - 15 und 19 - 20 hier beschriebenen verbesserten induktiven Sensortastschalter mit anderen Treiberschaltungen für induktiven Sensortastschalter einschließlich, jedoch nicht darauf beschränkt, der in Verbindung mit Fig. 2 beschriebenen Treiberschaltung des Standes der Technik verwendet werden.

Obwohl die Erfindung hier als in einem induktiven Sensortastschalter, seiner Anordnung und seiner Schaltung konkretisiert veranschaulicht und beschrieben worden ist, soll sie dennoch nicht nur auf die gezeigten Details beschränkt sein. Beispielsweise kann die induktive Tastschaltung der vorliegenden Erfindung so modifiziert sein, dass sie eine Referenzspule umfasst, die an einer Tastenposition der Tastatur ausgeführt ist. Bei einer solchen Konfiguration wird die Referenzspule verwendet, um die Driftkompensation als Standardreferenz, wobei keine Tastenbewegung erlaubt ist, zu unterstützen. Wie ersichtlich ist, können ohne Abweichung vom Leitgedanken der Erfindung die lediglich durch die zugefügten Ansprüche definiert wird, und im Umfang und Bereich von Entsprechungen der Ansprüche liegend verschiedene Modifikationen und konstruktive Veränderungen daran vorgenommen werden können.

## Patentansprüche

1. Anordnung für einen induktiven Sensortastschalter, die umfasst:
einen Benutzerschnittstelle-Frontplattenabschnitt (18, 218, 218', 318, 457, 610);
eine Sensorspule (14, 26, 110, 110a, 162, 214, 320, 510, 515, 520, 530, 540, 550), die auf einer Leiterplatte (19, 219, 229, 302, 355, 415, 445, 555, 630) angeordnet ist;
ein leitendes Target (12, 212, 330, 332, 334, 338, 510, 570), das zwischen dem Benutzerschnittstelle-Frontplattenabschnitt (18, 218, 218', 318, 457, 610) und der Sensorspule (14, 26, 110, 110a, 162, 214, 320, 510, 515, 520, 530, 540, 550) angeordnet ist;
einen Rahmen (216, 226, 310, 350, 420, 440, 560, 620), der zwischen der Leiterplatte (19, 219, 229, 302, 355, 415, 445, 555, 630) und dem Benutzerschnittstelle-Frontplattenabschnitt (18, 218, 218', 318, 457, 610) angeordnet ist, **dadurch gekennzeichnet, dass** der Rahmen (216, 226, 310, 350, 420, 440, 560, 620) einen Überbrückungsabschnitt (216a, 226a, 310a) umfasst, der eine oberste Oberfläche, die zur unteren Oberfläche des Benutzerschnittstelle-Frontplattenabschnitts (18, 218, 218', 318, 457, 610) benachbart ist, und eine unterste Oberfläche, die der Sensorspule (14, 26, 110, 110a, 162, 214, 320, 510, 515, 520, 530, 540, 550) zugewandt ist, besitzt, und
wobei das leitende Target (12, 212, 330, 332, 334, 338, 510, 570) nächstgelegen zur untersten Oberfläche des Überbrückungsabschnitts (216a, 226a, 310a) angeordnet ist, wodurch eine Durchbiegung des Frontplattenabschnitts (18, 218, 218', 318, 457, 610) über dem Rahmen (216, 226, 310, 350, 420, 440, 560, 620) zu einer Durchbiegung des Überbrückungsabschnitts (216a, 226a, 310a) und einer Bewegung wenigstens eines Abschnitts des leitenden Targets (12, 212, 330, 332, 334, 338, 510, 570) zur Sensorspule (14, 26, 110, 110a, 162, 214, 320, 510, 515, 520, 530, 540, 550) hin führt.

2. Anordnung nach Anspruch 1,
**dadurch gekennzeichnet,**
**dass** ein System (100) mehrere Anordnungen für einen induktiven Sensortastschalter (200, 220, 300, 340, 400, 430, 500, 550, 600) aufweist, wobei jede Sensorspule (14, 26, 110, 110a, 162, 214, 320, 510, 515, 520, 530, 540, 550) über eine gemeinsame Zuleitungsverbindung direkt mit Erde (112) verbunden ist.

3. Anordnung nach Anspruch 1 oder 2,
**dadurch gekennzeichnet,**
**dass** die Anordnung (200, 220, 300, 340, 400, 430, 500, 550, 600) ferner wenigstens einen Lichtemitter (230, 330, 410, 450) umfasst, der auf der Leiterplatte (19, 219, 229, 302, 355, 415, 445, 555, 630) angeordnet ist, und wobei wenigstens ein Abschnitt des Rahmens (216, 226, 310, 350, 420, 440, 560, 620) aus einem lichtdurchlässigen Material gefertigt ist, wobei der lichtdurchlässige Abschnitt des Rahmens (216, 226, 310, 350, 420, 440, 560, 620) in optischer Verbindung mit einem emittierenden Abschnitt des wenigstens einen Lichtemitters (230, 330, 410, 450) angeordnet ist.

4. Anordnung nach einem der vorhergehenden Ansprüche,
**dadurch gekennzeichnet,**
**dass** das Target (12, 212, 330, 332, 334, 338, 510, 570) direkt an der untersten Oberfläche des Überbrückungsabschnitts (216a, 226a, 310a) befestigt ist.

5. Anordnung nach Anspruch 4,
**dadurch gekennzeichnet,**
**dass** das leitende Target (12, 212, 330, 332, 334, 338, 510, 570) durch Heißprägen und/oder Drucken an der untersten Oberfläche des Überbrückungsabschnitts (216a, 226a, 310a) befestigt ist.

6. Anordnung nach Anspruch 4,
**dadurch gekennzeichnet,**
**dass** der Rahmen (216, 226, 310, 350, 420, 440, 560, 620) ferner einen Wulstabschnitt (310b, 350a, 560a) umfasst, der vom Überbrückungsabschnitt (216a, 226a, 310a) herab steht, wobei das leitende Target (12, 212, 330, 332, 334, 338, 510, 570) fern vom Überbrückungsabschnitt (216a, 226a, 310a) mit dem Wulstabschnitt (310b, 350a, 560a) in Verbindung stehend angeordnet ist.

7. Anordnung nach Anspruch 6,
**dadurch gekennzeichnet,**
**dass** das leitende Target (12, 212, 330, 332, 334, 338, 510, 570) am fernen Wulstabschnitt (310b, 350a, 560a) befestigt ist und über der Sensorspule (14, 26, 110, 110a, 162, 214, 320, 510, 515, 520, 530, 540, 550) schwebt.

8. Anordnung nach Anspruch 6,
**dadurch gekennzeichnet,**
**dass** das leitende Target (12, 212, 330, 332, 334, 338, 510, 570) eine leitende Kappe (330, 334) ist, die zwischen der Leiterplatte (19, 219, 229, 302, 355, 415, 445, 555, 630) und dem Wulstabschnitt (310b, 350a, 560a) und über der Sensorspule (14, 26, 110, 110a, 162, 214, 320, 510, 515, 520, 530, 540, 550) an der Leiterplatte (19, 219, 229, 302, 355, 415, 445, 555, 630) angebracht ist.

9. Anordnung nach Anspruch 1,
**dadurch gekennzeichnet,**
**dass** die Sensorspule (14, 26, 110, 110a, 162, 214, 320, 510, 515, 520, 530, 540, 550) einen ersten Satz von Windungen (510, 540), die in einer ersten Richtung drehen, und einen zweiten Satz von Windungen (520, 550), die in einer zweiten Richtung drehen, umfasst, wobei die zweite Richtung zur ersten Richtung entgegengesetzt ist, wobei der zweite Satz von Windungen (520, 550) den ersten Satz von Windungen (510, 540) umgibt.

10. Anordnung nach Anspruch 1,
**dadurch gekennzeichnet,**
**dass** die Sensorspule (14, 26, 110, 110a, 162, 214, 320, 510, 515, 520, 530, 540, 550) einen ersten Satz von Windungen (510) umfasst, wobei die Anordnung (200, 220, 300, 340, 400, 430, 500, 550, 600) ferner wenigstens eine zusätzliche Windung (520) umfasst, die außerhalb des ersten Satzes von Windungen (510) angeordnet ist, wobei die wenigstens eine zusätzliche Windung (520) zu einem Bezugspotential kurzgeschlossen ist.

11. Anordnung nach einem der vorhergehenden Ansprüche,
**dadurch gekennzeichnet,**
**dass** wenigstens eine Sensorspule (14, 26, 110, 110a, 162, 214, 320, 510, 515, 520, 530, 540, 550) eine Mehrebenen-Sensorspule (530) ist.

12. System für einen induktiven Sensortastschalter, das umfasst:
mehrere Anordnungen für einen induktiven Sensortastschalter (200, 220, 300, 340, 400, 430, 500, 550, 600) nach einem der Ansprüche 1 bis 11,
wobei jede der Anordnungen für den induktiven Sensortastschalter (200, 220, 300, 340, 400, 430, 500, 550, 600) ein leitendes Target (12, 212, 330, 332, 334, 338, 510, 570) umfasst, das mit einer Sensorspule (14, 26, 110, 110a, 162, 214, 320, 510, 515, 520, 530, 540, 550) gekoppelt ist;
mehrere Treiberschaltungen (120), die einen Treiberstrom erzeugen, wobei jede der mehreren Treiberschaltungen (120) ihren eigenen Treibertransistor (T1) umfasst und
wobei jede der mehreren Treiberschaltungen (120) nur an eine der mehreren Anordnungen für induktiven Sensortastschalter (200, 220, 300, 340, 400, 430, 500, 550, 600) einen Treiberstrom liefert.

13. System nach Anspruch 12,
**dadurch gekennzeichnet,**
**dass** jede der mehreren Treiberschaltungen (120) lokal zu jener Anordnung für den induktiven Sensortastschalter(200, 220, 300, 340, 400, 430, 500, 550, 600), zu der sie einen Treiberstrom liefert, auf der Leiterplatte (19, 219, 229, 302, 355, 415, 445, 555, 630) angeordnet ist.

14. System nach Anspruch 12 oder 13,
**dadurch gekennzeichnet,**
**dass** wenigstens eine der mehreren Anordnung für einen induktiven Sensortastschalter (200, 220, 300, 340, 400, 430, 500, 550, 600) einen Frontplattenabschnitt (18, 218, 218', 318, 457, 610) umfasst, wobei das leitende Target (12, 212, 330, 332, 334, 338, 510, 570) zur Sensorspule (14, 26, 110, 110a, 162, 214, 320, 510, 515, 520, 530, 540, 550) der wenigstens einen Anordnung für einen induktiven Sensortastschalter (200, 220, 300, 340, 400, 430, 500, 550, 600) benachbart, jedoch von dieser beabstandet angeordnet ist, wobei die Sensorspule (14, 26, 110, 110a, 162, 214, 320, 510, 515, 520, 530, 540, 550) auf einer Leiterplatte (19, 219, 229, 302, 355, 415, 445, 555, 630) angeordnet ist.

15. System nach Anspruch 14,
**dadurch gekennzeichnet,**
**dass** eine zweite Leiterplatte (565) zwischen der Leiterplatte (19, 219, 229, 302, 355, 415, 445, 555, 630) mit der Sensorspule (14, 26, 110, 110a, 162, 214, 320, 510, 515, 520, 530, 540, 550) und dem Frontplattenabschnitt (18, 218, 218', 318, 457, 610) und
ein Rahmen (216, 226, 310, 350, 420, 440, 560, 620) zwischen der zweiten Leiterplatte (565) und dem Frontplattenabschnitt (18, 218, 218', 318, 457, 610) angeordnet ist.

16. System nach Anspruch 15,
**dadurch gekennzeichnet,**
**dass** der Rahmen (216, 226, 310, 350, 420, 440, 560, 620) den Überbrückungsabschnitt (216a, 226a, 310a) umfasst, der eine oberste Oberfläche, die zu einer unteren Oberfläche des Frontplattenabschnitts (18, 218, 218', 318, 457, 610) benachbart ist, und eine unterste Oberfläche, die der zweiten Leiterplatte (565) zugewandt ist, aufweist.

17. System nach Anspruch 15 oder 16,
**dadurch gekennzeichnet,**
**dass** der Rahmen (216, 226, 310, 350, 420, 440, 560, 620) einen Wulstabschnitt (310b, 350a, 560a) umfasst, der von der untersten Oberfläche des Überbrückungsabschnitts (216a, 226a, 310a) herab steht, wobei der ferne Abschnitt des Wulstabschnitts (310b, 350a, 560a) zu einem Abschnitt einer vorderen Oberfläche der zweiten Leiterplatte (565) benachbart oder mit diesem in Verbindung stehend angeordnet ist.

18. System nach Anspruch 17,
**dadurch gekennzeichnet,**
**dass** das leitende Target (12, 212, 330, 332, 334, 338, 510, 570) an einem Abschnitt einer hinteren Oberfläche der zweiten Leiterplatte (565) unter dem Wulstabschnitt (310b, 350a, 560a) angeordnet ist, so dass eine Durchbiegung des Frontplattenabschnitts (18, 218, 218', 318, 457, 610) über dem Rahmen (216, 226, 310, 350, 420, 440, 560, 620) zu einer Durchbiegung des Überbrückungsabschnitts (216a, 226a, 310a) führt, deren Kraft durch den Wulstabschnitt (310b, 350a, 560a) auf die zweite Leiterplatte (565) übertragbar ist, womit die zweite Leiterplatte (565) durchbiegbar ist und die Kopplung des leitenden Targets (12, 212, 330, 332, 334, 338, 510, 570) mit der Sensorspule (14, 26, 110, 110a, 162, 214, 320, 510, 515, 520, 530, 540, 550) veränderbar ist.

19. System nach einem der vorhergehenden Ansprüche,
**dadurch gekennzeichnet,**
**dass** jede Anordnung für die induktive Sensortaste (200, 220, 300, 340, 400, 430, 500, 550, 600) ein lichtdurchlässiges Tastenelement umfasst, das durch einen Rahmen (216, 226, 310, 350, 420, 440, 560, 620) unterstützt ist, wobei das Target (12, 212, 330, 332, 334, 338, 510, 570) auf einer rückwärtigen Außenfläche des lichtdurchlässigen Tastenelements angeordnet ist.

## Claims

1. Arrangement for an inductive sensor touch switch, which arrangement comprises:
a user interface front panel section (18, 218, 218', 318, 457, 610);
a sensor coil (14, 26, 110, 110a, 162, 214, 320, 510, 515, 520, 530, 540, 550) which is arranged on a printed circuit board (19, 219, 229, 302, 355, 415, 445, 555, 630);
a conductive target (12, 212, 330, 332, 334, 338, 510, 570) which is arranged between the user interface front panel section (18, 218, 218', 318, 457, 610) and the sensor coil (14, 26, 110, 110a, 162, 214, 320, 510, 515, 520, 530, 540, 550);
a frame (216, 226, 310, 350, 420, 440, 560, 620) which is arranged between the printed circuit board (19, 219, 229, 302, 355, 415, 445, 555, 630) and the user interface front panel section (18, 218, 218', 318, 457, 610), **characterized in that** the frame (216, 226, 310, 350, 420, 440, 560, 620) comprises a bridging section (216a, 226a, 310a) which has an uppermost surface, which is adjacent to the lower surface of the user interface front panel section (18, 218, 218', 318, 457, 610), and a lowermost surface, which faces the sensor coil (14, 26, 110, 110a, 162, 214, 320, 510, 515, 520, 530, 540, 550), and wherein the conductive target (12, 212, 330, 332, 334, 338, 510, 570) is arranged closest to the lowermost surface of the bridging section (216a, 226a, 310a), as a result of which a deflection of the front panel section (18, 218, 218', 318, 457, 610) above the frame (216, 226, 310, 350, 420, 440, 560, 620) leads to a deflection of the bridging section (216a, 226a, 310a) and a movement of at least one section of the conductive target (12, 212, 330, 332, 334, 338, 510, 570) in the direction of the sensor coil (14, 26, 110, 110a, 162, 214, 320, 510, 515, 520, 530, 540, 550).

2. Arrangement according to Claim 1, **characterized in that** a system (100) has a plurality of arrangements for an inductive sensor touch switch (200, 220, 300, 340, 400, 430, 500, 550, 600), wherein each sensor coil (14, 26, 110, 110a, 162, 214, 320, 510, 515, 520, 530, 540, 550) is connected directly to earth (112) by means of a common supply line connection.

3. Arrangement according to Claim 1 or 2, **characterized in that** the arrangement (200, 220, 300, 340, 400, 430, 500, 550, 600) further comprises at least one light emitter (230, 330, 410, 450) which is arranged on the printed circuit board (19, 219, 229, 302, 355, 415, 445, 555, 630), and wherein at least one section of the frame (216, 226, 310, 350, 420, 440, 560, 620) is produced from a transparent material, wherein the transparent section of the frame (216, 226, 310, 350, 420, 440, 560, 620) is arranged such that it is optically connected to an emitting section of the at least one light emitter (230, 330, 410, 450).

4. Arrangement according to one of the preceding claims, **characterized in that** the target (12, 212, 330, 332, 334, 338, 510, 570) is attached directly to the lowermost surface of the bridging section (216a, 226a, 310a).

5. Arrangement according to Claim 4, **characterized in that** the conductive target (12, 212, 330, 332, 334, 338, 510, 570) is attached to the lowermost surface of the bridging section (216a, 226a, 310a) by hot-stamping and/or printing.

6. Arrangement according to Claim 4, **characterized in that** the frame (216, 226, 310, 350, 420, 440, 560, 620) further comprises a bead section (310b, 350a, 560a) which protrudes from the bridging section (216a, 226a, 310a), wherein the conductive target (12, 212, 330, 332, 334, 338, 510, 570) is arranged at a distance from the bridging section (216a, 226a, 310a) such that it is connected to the bead section (310b, 350a, 560a).

7. Arrangement according to Claim 6, **characterized in that** the conductive target (12, 212, 330, 332, 334, 338, 510, 570) is attached to the remote bead section (310b, 350a, 560a) and hovers above the sensor coil (14, 26, 110, 110a, 162, 214, 320, 510, 515, 520, 530, 540, 550).

8. Arrangement according to Claim 6, **characterized in that** the conductive target (12, 212, 330, 332, 334, 338, 510, 570) is a conductive cap (330, 334) which is fitted between the printed circuit board (19, 219, 229, 302, 355, 415, 445, 555, 630) and the bead section (310b, 350a, 560a) and above the sensor coil (14, 26, 110, 110a, 162, 214, 320, 510, 515, 520, 530, 540, 550) on the printed circuit board (19, 219, 229, 302, 355, 415, 445, 555, 630).

9. Arrangement according to Claim 1, **characterized in that** the sensor coil (14, 26, 110, 110a, 162, 214, 320, 510, 515, 520, 530, 540, 550) comprises a first set of turns (510, 540), which rotate in a first direction, and a second set of turns (520, 550), which rotate in a second direction, wherein the second direction is opposite to the first direction, wherein the second set of turns (520, 550) surrounds the first set of turns (510, 540).

10. Arrangement according to Claim 1, **characterized in that** the sensor coil (14, 26, 110, 110a, 162, 214, 320, 510, 515, 520, 530, 540, 550) comprises a first set of turns (510), wherein the arrangement (200, 220, 300, 340, 400, 430, 500, 550, 600) further comprises at least one additional turn (520) which is arranged outside the first set of turns (510), wherein the at least one additional turn (520) is short-circuited to form a reference potential.

11. Arrangement according to one of the preceding claims, **characterized in that** at least one sensor coil (14, 26, 110, 110a, 162, 214, 320, 510, 515, 520, 530, 540, 550) is a multi-plane sensor coil (530).

12. System for an inductive sensor touch switch, which system comprises a plurality of arrangements for an inductive sensor touch switch (200, 220, 300, 340, 400, 430, 500, 550, 600) according to one of Claims 1 to 11, wherein each of the arrangements for the inductive sensor touch switch (200, 220, 300, 340, 400, 430, 500, 550, 600) comprises a conductive target (12, 212, 330, 332, 334, 338, 510, 570) which is coupled to a sensor coil (14, 26, 110, 110a, 162, 214, 320, 510, 515, 520, 530, 540, 550);
a plurality of driver circuits (120) which generate a driver current, wherein each of the plurality of driver circuits (120) comprises its own driver transistor (T1), and wherein each of the plurality of driver circuits (120) supplies a driver current only to one of the plurality of arrangements for inductive sensor touch switches (200, 220, 300, 340, 400, 430, 500, 550, 600).

13. System according to Claim 12, **characterized in that** each of the plurality of driver circuits (120) is arranged on the printed circuit board (19, 219, 229, 302, 355, 415, 445, 555, 630) locally to that arrangement for the inductive sensor touch switch (200, 220, 300, 340, 400, 430, 500, 550, 600) to which it supplies a driver current.

14. System according to Claim 12 or 13, **characterized in that** at least one of the plurality of arrangements for an inductive sensor touch switch (200, 220, 300, 340, 400, 430, 500, 550, 600) comprises a front panel section (18, 218, 218', 318, 457, 610), wherein the conductive target (12, 212, 330, 332, 334, 338, 510, 570) is arranged adjacent to and at a distance from the sensor coil (14, 26, 110, 110a, 162, 214, 320, 510, 515, 520, 530, 540, 550) of the at least one arrangement for an inductive sensor touch switch (200, 220, 300, 340, 400, 430, 500, 550, 600), wherein the sensor coil (14, 26, 110, 110a, 162, 214, 320, 510, 515, 520, 530, 540, 550) is arranged on a printed circuit board (19, 219, 229, 302, 355, 415, 445, 555, 630).

15. System according to Claim 14, **characterized in that** a second printed circuit board (565) is arranged between the printed circuit board (19, 219, 229, 302, 355, 415, 445, 555, 630) with the sensor coil (14, 26, 110, 110a, 162, 214, 320, 510, 515, 520, 530, 540, 550) and the front panel section (18, 218, 218', 318, 457, 610), and a frame (216, 226, 310, 350, 420, 440, 560, 620) is arranged between the second printed circuit board (565) and the front panel section (18, 218, 218', 318, 457, 610).

16. System according to Claim 15, **characterized in that** the frame (216, 226, 310, 350, 420, 440, 560, 620) comprises the bridging section (216a, 226a, 310a) which has an uppermost surface, which is adjacent to a lower surface of the front panel section (18, 218, 218', 318, 457, 610), and a lowermost surface, which faces the second printed circuit board (565).

17. System according to Claim 15 or 16, **characterized in that** the frame (216, 226, 310, 350, 420, 440, 560, 620) comprises a bead section (310b, 350a, 560a) which projects from the lowermost surface of the bridging section (216a, 226a, 310a), wherein the remote section of the bead section (310b, 350a, 560a) is arranged adjacent to a section of a front surface of the second printed circuit board (565) or such that it is connected to the said section.

18. System according to Claim 17, **characterized in that** the conductive target (12, 212, 330, 332, 334, 338, 510, 570) is arranged on a section of a rear surface of the second printed circuit board (565) beneath the bead section (310b, 350a, 560a), so that a deflection of the front panel section (18, 218, 218', 318, 457, 610) above the frame (216, 226, 310, 350, 420, 440, 560, 620) leads to a deflection of the bridging section (216a, 226a, 310a), it being possible for the force of the said deflection to be transmitted to the second printed circuit board (565) by the bead section (310b, 350a, 560a), as a result of which the second printed circuit board (565) can be deflected and the coupling between the conductive target (12, 212, 330, 332, 334, 338, 510, 570) and the sensor coil (14, 26, 110, 110a, 162, 214, 320, 510, 515, 520, 530, 540, 550) can be varied.

19. System according to one of the preceding claims, **characterized in that** each arrangement for the inductive sensor button (200, 220, 300, 340, 400, 430, 500, 550, 600) comprises a transparent touch-operated element which is supported by a frame (216, 226, 310, 350, 420, 440, 560, 620), wherein the target (12, 212, 330, 332, 334, 338, 510, 570) is arranged on a rear outer face of the transparent touch-operated element.

## Revendications

1. Agencement pour un bouton-poussoir de détection inductif qui comprend :
une section de platine avant d'interface d'utilisateur (18, 218, 218', 318, 457, 610) ;
une bobine de détection (14, 26, 110, 110a, 162, 214, 320, 510, 515, 520, 530, 540, 550) qui est disposée sur une carte de circuit imprimé (19, 219, 229, 302, 355, 415, 445, 555, 630) ;
une cible conductrice (12, 212, 330, 332, 334, 338, 510, 570) qui est disposée entre la section de platine avant d'interface d'utilisateur (18, 218, 218', 318, 457, 610) et la bobine de détection (14, 26, 110, 110a, 162, 214, 320, 510, 515, 520, 530, 540, 550) ;
un cadre (216, 226, 310, 350, 420, 440, 560, 620) qui est disposé entre la carte de circuit imprimé (19, 219, 229, 302, 355, 415, 445, 555, 630) et la section de platine avant d'interface d'utilisateur (18, 218, 218', 318, 457, 610)**caractérisé en ce que** le cadre (216, 226, 310, 350, 420, 440, 560, 620) comprend une section de pontage (216a, 226a, 310a) qui possède une surface la plus haute qui est adjacente à la surface inférieure de la section de platine avant d'interface d'utilisateur (18, 218, 218', 318, 457, 610) et une surface la plus basse qui est tournée vers la bobine de détection (14, 26, 110, 110a, 162, 214, 320, 510, 515, 520, 530, 540, 550), et
pour lequel la cible conductrice (12, 212, 330, 332, 334, 338, 510, 570) est disposée le plus proche de la surface la plus basse de la section de pontage (216a, 226a, 310a) par laquelle une flexion de la section de platine avant (18, 218, 218', 318, 457, 610) conduit par le cadre (216, 226, 310, 350, 420, 440, 560, 620) à une flexion de la section de pontage (216a, 226a, 310a) et à un mouvement d'au moins une section de la cible conductrice (12, 212, 330, 332, 334, 338, 510, 570) à la bobine de détection (14, 26, 110, 110a, 162, 214, 320, 510, 515, 520, 530, 540, 550).

2. Agencement selon la revendication 1 **caractérisé en ce qu'**un système (100) présente plusieurs agencements pour un bouton-poussoir de détection inductif (200, 220, 300, 340, 400, 430, 500, 550, 600) pour lequel chaque bobine de détection (14, 26, 110, 110a, 162, 214, 320, 510, 515, 520, 530, 540, 550) est reliée directement à la terre (112) par une liaison d'alimentation commune.

3. Agencement selon la revendication 1 ou 2 **caractérisé en ce que** l'agencement (200, 220, 300, 340, 400, 430, 500, 550, 600) comprend en plus au moins un émetteur de lumière (230, 330, 410, 450) qui est disposé sur la carte de circuit imprimé (19, 219, 229, 302, 355, 415, 445, 555, 630) et pour lequel au moins une section du cadre (216, 226, 310, 350, 420, 440, 560, 620) est fabriquée en matériau transparent, pour lequel la section transparente du cadre (216, 226, 310, 350, 420, 440, 560, 620) est disposée en liaison optique avec une section émettrice de l'au moins un émetteur de lumière (230, 330, 410, 450).

4. Agencement selon une quelconque des revendications précédentes **caractérisé en ce que** la cible (12, 212, 330, 332, 334, 338, 510, 570) est fixée directement à la surface la plus basse de la section de pontage (216a, 226a, 310a).

5. Agencement selon la revendication 4 **caractérisé en ce que** la cible conductrice (12, 212, 330, 332, 334, 338, 510, 570) est fixée par estampage à chaud et/ou impression à la surface la plus basse de la section de pontage (216a, 226a, 310a).

6. Agencement selon la revendication 4 **caractérisé en ce que** le cadre (216, 226, 310, 350, 420, 440, 560, 620) comprend en plus une section à bourrelet (310b, 350a, 560a) qui descend de la section de pontage (216a, 226a, 310a), pour lequel la cible conductrice (12, 212, 330, 332, 334, 338, 510, 570) est disposée loin de la section de pontage (216a, 226a, 310a) en liaison avec la section à bourrelet (310b, 350a, 560a).

7. Agencement selon la revendication 6 **caractérisé en ce que** la cible conductrice (12, 212, 330, 332, 334, 338, 510, 570) est fixée sur la section à bourrelet (310b, 350a, 560a) éloignée et est en suspension au-dessus de la bobine de détection (14, 26, 110, 110a, 162, 214, 320, 510, 515, 520, 530, 540, 550).

8. Agencement selon la revendication 6 **caractérisé en ce que** la cible conductrice (12, 212, 330, 332, 334, 338, 510, 570) est un capuchon conducteur (330, 334) qui est monté entre la carte de circuit imprimé (19, 219, 229, 302, 355, 415, 445, 555, 630) et la section à bourrelet (310b, 350a, 560a) et au-dessus de la bobine de détection (14, 26, 110, 110a, 162, 214, 320, 510, 515, 520, 530, 540, 550) au niveau de la carte de circuit imprimé (19, 219, 229, 302, 355, 415, 445, 555, 630).

9. Agencement selon la revendication 1 **caractérisé en ce que** la bobine de détection (14, 26, 110, 110a, 162, 214, 320, 510, 515, 520, 530, 540, 550) comprend un premier jeu de spires (510, 540) qui tournent dans une première direction et un deuxième jeu de spires (520, 550) qui tournent dans une deuxième direction, la deuxième direction étant opposée à la première direction, le deuxième jeu de spires (520, 550) entourant le premier jeu de spires (510, 540).

10. Agencement selon la revendication 1 **caractérisé en ce que** la bobine de détection (14, 26, 110, 110a, 162, 214, 320, 510, 515, 520, 530, 540, 550) comprend un premier jeu de spires (510), l'agencement (200, 220, 300, 340, 400, 430, 500, 550, 600) comprenant en plus au moins une spire supplémentaire (520) qui est disposée en dehors du premier jeu de spires (510), l'au moins une spire supplémentaire (520) étant court-circuitée à un potentiel de référence.

11. Agencement selon une quelconque des revendications précédentes **caractérisé en ce qu'**au moins une bobine de détection (14, 26, 110, 110a, 162, 214, 320, 510, 515, 520, 530, 540, 550) est une bobine de détection multiniveau (530).

12. Système pour un bouton-poussoir de détection inductif qui comprend :
plusieurs agencements pour un bouton-poussoir de détection inductif (200, 220, 300, 340, 400, 430, 500, 550, 600) selon une quelconque des revendications 1 à 11,
pour lequel chacun des agencements pour le bouton-poussoir de détection inductif (200, 220, 300, 340, 400, 430, 500, 550, 600) comprend une cible conductrice (12, 212, 330, 332, 334, 338, 510, 570) qui est couplée avec une bobine de détection (14, 26, 110, 110a, 162, 214, 320, 510, 515, 520, 530, 540, 550),
plusieurs circuits pilotes (120) qui produisent un courant d'attaque, chacun des plusieurs circuits pilotes (120) comprenant son propre transistor pilote (T1) et
chacun des plusieurs circuits pilotes (120) ne fournissant un courant d'attaque qu'à un des plusieurs agencements pour le bouton-poussoir de détection inductif (200, 220, 300, 340, 400, 430, 500, 550, 600).

13. Système selon la revendication 12 **caractérisé en ce que** chacun des plusieurs circuits pilotes (120) est localement disposé sur la carte de circuit imprimé (19, 219, 229, 302, 355, 415, 445, 555, 630) à chaque agencement pour le bouton-poussoir de détection inductif (200, 220, 300, 340, 400, 430, 500, 550, 600) auquel il fournit un courant d'attaque.

14. Système selon la revendication 12 ou 13 **caractérisé en ce qu'**au moins un des plusieurs agencements pour un bouton-poussoir de détection inductif (200, 220, 300, 340, 400, 430, 500, 550, 600) comprend une section de platine avant (18, 218, 218', 318, 457, 610) pour lequel la cible conductrice (12, 212, 330, 332, 334, 338, 510, 570) est adjacente à la bobine de détection (14, 26, 110, 110a, 162, 214, 320, 510, 515, 520, 530, 540, 550) de l'au moins un agencement pour un bouton-poussoir de détection inductif (200, 220, 300, 340, 400, 430, 500, 550, 600), mais est toutefois disposée à distance de celle-ci, la bobine de détection (14, 26, 110, 110a, 162, 214, 320, 510, 515, 520, 530, 540, 550) étant disposée sur une carte de circuit imprimé (19, 219, 229, 302, 355, 415, 445, 555, 630).

15. Système selon la revendication 14 **caractérisé en ce qu'**une deuxième carte de circuit imprimé (565) est disposée entre la carte de circuit imprimé (19, 219, 229, 302, 355, 415, 445, 555, 630) avec la bobine de détection (14, 26, 110, 110a, 162, 214, 320, 510, 515, 520, 530, 540, 550) et la section de platine avant (18, 218, 218', 318, 457, 610) et un cadre (216, 226, 310, 350, 420, 440, 560, 620) est disposé entre la deuxième carte de circuit imprimé (565) et la section de platine avant (18, 218, 218', 318, 457, 610).

16. Système selon la revendication 15 **caractérisé en ce que** le cadre (216, 226, 310, 350, 420, 440, 560, 620) comprend la section de pontage (216a, 226a, 310a) qui présente une surface la plus haute qui est adjacente à une surface inférieure de la section de platine avant (18, 218, 218', 318, 457, 610) et une surface la plus basse qui est tournée vers la deuxième carte de circuit imprimé (565).

17. Système selon la revendication 15 ou 16 **caractérisé en ce que** le cadre (216, 226, 310, 350, 420, 440, 560, 620) comprend une section à bourrelet (310b, 350a, 560a) qui descend de la surface la plus basse de la section de pontage (216a, 226a, 310a), la section éloignée de la section à bourrelet (310b, 350a, 560a) étant adjacente à une section d'une surface avant de la deuxième carte de circuit imprimé (565) ou étant disposée en liaison avec celle-ci.

18. Système selon la revendication 17 **caractérisé en ce que** la cible conductrice (12, 212, 330, 332, 334, 338, 510, 570) est disposée sur une section d'une surface arrière de la deuxième carte de circuit imprimé (565) sous la section à bourrelet (310b, 350a, 560a) de sorte qu'une flexion de la section de platine avant (18, 218, 218', 318, 457, 610) conduit au-dessus du cadre (216, 226, 310, 350, 420, 440, 560, 620) à une flexion de la section de pontage (216a, 226a, 310a) dont la force est transmissible par la section à bourrelet (310b, 350a, 560a) à la deuxième carte de circuit imprimé (565), la deuxième carte de circuit imprimé (565) étant de ce fait fléchissable et le couplage de la cible conductrice (12, 212, 330, 332, 334, 338, 510, 570) à la bobine de détection (14, 26, 110, 110a, 162, 214, 320, 510, 515, 520, 530, 540, 550) étant modifiable.

19. Système selon une quelconque des revendications précédentes **caractérisé en ce que** chaque agencement pour le bouton-poussoir de détection inductif (200, 220, 300, 340, 400, 430, 500, 550, 600) comprend un élément poussoir transparent qui est supporté par un cadre (216, 226, 310, 350, 420, 440, 560, 620), la cible (12, 212, 330, 332, 334, 338, 510, 570) étant disposée sur une surface extérieure arrière de l'élément poussoir transparent.
